(19) Europäisches Patentamt
European Patent Office
Office européen des brevets

(11) **EP 0 909 029 B1**

(12) **EUROPÄISCHE PATENTSCHRIFT**

(45) Veröffentlichungstag und Bekanntmachung des Hinweises auf die Patenterteilung:
**16.04.2008 Patentblatt 2008/16**

(51) Int Cl.:
**H03H 21/00** *(2006.01)*

(21) Anmeldenummer: **98117149.9**

(22) Anmeldetag: **10.09.1998**

(54) **Verfahren zur Adaption von Filterkoeffizienten und adaptive Digitalfiltereinrichtung**

Filter coefficients adaptation method and adaptive digital filter device

Méthode d'adaptation des coefficients de filtrage et dispositif de filtrage numérique adaptatif

(84) Benannte Vertragsstaaten:
**DE FR GB IT**

(30) Priorität: **12.09.1997 DE 19740219**

(43) Veröffentlichungstag der Anmeldung:
**14.04.1999 Patentblatt 1999/15**

(73) Patentinhaber: **SIEMENS AKTIENGESELLSCHAFT**
**80333 München (DE)**

(72) Erfinder: **Lucioni, Gonzalo**
**58454 Witten (DE)**

(56) Entgegenhaltungen:
**EP-A- 0 554 494       US-A- 5 267 266**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Ein adaptives Digitalfilter zeichnet sich gegenüber einem konstanten Digitalfilter dadurch aus, daß seine Filterkoeffizienten, die seine Übertragungsfunktion und damit seine Übertragungseigenschaften bestimmen, je nach seiner Verwendung optimal an die gegebenen Betriebsbedingungen angepaßt werden können. Solche adaptive Digitalfilter sind in vielen Bereichen der zeitdiskreten Signalverarbeitung von Bedeutung. So werden sie bei der Sprachverarbeitung, z.B. in Ansagesystemen, zur Echokompensation verwendet und diesem Zusammenhang als Echounterdrückungsfilter bezeichnet.

Sprachgesteuerte Ansagesysteme ermöglichen es einem Benutzer, über seine Spracheingabe Informationen abzufragen, die in dem Ansagesystem gespeichert sind. Der Benutzer kann mittels dieser Ansagesysteme beispielsweise Transaktionen, z.B. Geldüberweisungen oder Bestellungen, auf besonders bequeme Weise ausführen. Adaptive Echounterdrückungsfilter haben in diesen Ansagesystemen die Aufgabe, die Spracheingabe des Benutzers von dem Ansageecho zu befreien, das unter sogenannten "double talking"-Bedingungen, d.h. bei einer zeitlichen Überlagerung von Ansage und Spracheingabe in die Spracheingabe mit eingeht. Solche "double talking"-Bedingungen treten in bekannten Ansagesystemen häufig auf. So geht aus einem Feldversuch, wiedergegeben in "A voice-activated telephone exchange system and its field trial", S. Yamamoto, K. Takeda, N. Inone, S. Kuroiwa, M. Naitoh, Proceedings of 2nd IEEE Workshop on Interactive Voice Technology for Telecommunications Applications, Kyoto, Japan 26-27 Sept. 1994, Seiten 21 bis 26 hervor, daß über 60 % der Benutzer bereits vor dem Ende der Ansage mit dem Sprechen begonnen haben.

In dem oben genannten Versuch wird ferner berichtet, daß die Spracheingabe bereits eine Sekunde nach Beginn der ersten Ansage des Ansagesystems erfolgen kann. Da die Filterkoeffizienten von Echounterdrückungsfiltern unter den Bedingungen gleichzeitig auftretender Ansage und Sprache möglichst nicht adaptiert werden sollen, wie beispielsweise in "Adaptive Echo Cancellation for Speech Signals", M. Sondhi, W.L. Kellermann, aus Advances in Speech Signal Processing von S. Furui, M. Sondhi, 1992, Seiten 327 bis 356, dargelegt ist, steht etwa nur eine Sekunde zur Verfügung, die Filterkoeffizienten des Echounterdrückungsfilters anzupassen. Es sind somit hohe Anforderungen an die Konvergenz der verwendeten Koeffizientenadaption zu stellen. Mit Konvergenz ist im folgenden die Geschwindigkeit gemeint, mit der die Filterkoeffizienten an ihre optimalen Werte angenähert werden, d.h. an die Werte, welche die gewünschten Übertragungseigenschaften des Echounterdrückungsfilters liefern.

Die Filterkoeffizienten bekannter adaptiver Echounterdrückungsfilter werden z.B. nach dem Least-Mean-Square-Algorithmus, kurz LMS-Algorithmus, adaptiert. Bei dem LMS-Algorithmus wird ein Satz von Filterkoeffizienten so angepaßt, daß der mittlere quadratische Fehler eines Ausgangssignals des Echounterdrückungsfilters, oder allgemein des adaptiven Digitalfilters, gegenüber einem Referenzsignal minimiert wird. Der LMS-Algorithmus zeichnet sich zwar gegenüber anderen Verfahren, wie etwa dem Newton-Verfahren, durch einen geringen Rechen- und damit Realisierungsaufwand aus, zeigt jedoch nicht immer zufriedenstellende Konvergenzeigenschaften. Dies ist zum Teil darin begründet, daß der LMS-Algorithmus von der Annahme stationärer, stochastischer Signale ausgeht, was bekanntlich für Sprachsignale nicht zutreffend ist. Andere bekannte Verfahren für adaptive nichtrekursive Digitalfilter haben zwar gute Konvergenzeigenschaften, sind jedoch sehr rechenaufwendig und müssen deshalb z.B. durch komplexe Schaltungsanordnungen realisiert werden.

In der Europäischen Patentschrift O 554 494 B1 ist ein nach dem LMS-Algorithmus arbeitendes adaptives nichtrekursives Digitalfilter beschrieben. Auf Seite 4, Zeilen 30 bis 56 der Beschreibung ist erläutert, daß durch Abtastratenerhöhung bei der Adaption der Filterkoeffizienten die Konvergenz des LMS-Algorithmus unter den in der angegebenen Textstelle erläuterten Voraussetzungen verbessert werden kann. Der Anwendungsbereich des in der oben genannten Patentschrift beschriebenen adaptiven nichtrekursiven Digitalfilters ist jedoch aufgrund seiner konkreten Ausgestaltung eng begrenzt.

Aufgabe der Erfindung ist es, ein Verfahren zur schnell konvergierenden Koeffizientenadaption in einer Digitalfiltereinrichtung anzugeben, das einen breiten Anwendungsbereich hat und technisch auf einfache Weise zu realisieren ist.

Die Erfindung löst diese Aufgabe durch ein Verfahren, bei dem die Abtastrate eines digitalen Eingangssignals und eines digitalen Referenzsignals von einem vorgegeben niedrigen Wert um einen Faktor M auf einen vorgegebenen hohen Wert erhöht wird, und die Abtastwerte des mit der hohen Abtastrate abgetasteten Eingangssignals und des mit der hohen Abtastrate abgetasteten Referenzsignals zumindest bis zu einem gewissen Grad dekorreliert werden. Ein nichtrekursives adaptives Digitalfilter erzeugt aus dem dekorrelierten Eingangssignal ein Kompensationssignal, basierend auf N Filterkoeffizienten, die in einer mit der hohen Abtastrate betriebenen Adaptionseinheit in Abhängigkeit eines Differenzsignals aus dekorreliertem Referenzsignal und Kompensationssignal entsprechend den kleinsten mittleren Fehlerquadraten bestimmt werden. Die Abtastrate des Differenzsignals wird von dem vorgegebenen hohen Wert um den Faktor M auf den vorgegebenen niedrigen Wert verringert.

Bei dem erfindungsgemäßen Verfahren werden das Eingangssignal und das Referenzsignal interpoliert, indem die Abtastrate erhöht wird und die so modifizierten Signale dekorreliert werden. Da die Adaptionseinheit des nichtrekursiven adaptiven Digitalfilters die interpolierten Signale mit der hohen Abtastrate verarbeiten kann, und, wie oben erwähnt, jeder zusätzliche Adaptionsschritt innerhalb des LMS-Verfahrens die Anpassung der Filterkoeffizienten beschleunigt, ist durch die Erfindung ein schnell konvergierendes Adaptionsverfahren gegeben. Gegenüber bekannten Verfahren zur schnell konvergierenden Koeffizientenadaption kann das erfindungsgemäße Verfahren vergleichsweise aufwandsarm realisiert werden. Dies kann in einer direkten schaltungstechnischen Umsetzung unter Verwendung von anwendungsspezifischen integrierten Schaltkreisen, sogenannten ASIC-Bausteinen, oder in einer programmgesteuerten Signalverarbeitungseinrichtung geschehen.

Neben der Abtastratenerhöhung sorgt die Dekorrelation des Eingabesignals und des Referenzsignals zusätzlich für eine Verbesserung des Konvergenzverhaltens der Koeffizientenadaption. Das Konvergenzverhalten des LMS-Algorithmus ist für solche Signale am besten, deren Abtastwerte völlig unkorreliert sind. Solche Signale bezeichnet man auch als weißes Rauschen. Je umfassender das Eingangssignal und das Referenzsignal dekorreliert werden, desto schneller kann ein Satz optimaler Filterkoeffizienten ermittelt werden.

Das Verfahren kann in einem sprachgesteuerten Ansagesystem zur Echokompensation verwendet werden. In diesem Fall ist das Eingabesignal durch ein Ansagesignal und das Referenzsignal durch ein Spracheingabesignal gegeben. Aus dem Ansagesignal wird ein Kompensationssignal gewonnen, das ein in dem Spracheingabesignal enthaltenes Ansageecho nachbilden soll. Da die Anpassung der Filterkoeffizienten, wie oben erwähnt, in einer Phase erfolgt, in der ein Benutzer keine Spracheingabe vornimmt, ist das Spracheingabesignal, d.h. das Referenzsignal, während der Koeffizientenadaption allein durch das Ansageecho gegeben. Nach erfolgter Koeffizientenadaption stellt so das Differenzsignal das von dem Ansageecho befreite Spracheingabesignal dar.

Wird das Verfahren in einem Ansagesystem verwendet, so ist es günstig, die Abtastwerte des mit der hohen Abtastrate abgetasteten Eingangssignals und des mit der hohen Abtastrate abgetasteten Referenzsignals in gleicher Weise zu dekorrelieren und mindestens für die den ursprünglichen Abtastzeitpunkten zugeordneten Abtastwerte des Differenzsignals eine Kompensation der Dekorrelation vorzunehmen. Es wird so für die den ursprünglichen Abtastzeitpunkten zugeordneten Abtastwerte des Differenzsignals sichergestellt, daß die auf die Dekorrelation des Spracheingabesignals zurückzuführenden Signalveränderungen des Differenzsignals ausgeglichen werden. Die Spracheingabe stellt sich so nach erfolgter Interpolation und Abtastratenverringerung ebenso dar wie vorher. Sie wird insbesondere durch die eben erläuterten Verfahrensschritte nicht verfälscht und kann deshalb in dem Ansagesystem weiter verarbeitet werden.

Das Eingangssignal und das Referenzsignal können einer ersten und einer zweiten Interpolationseinrichtung zugeführt werden, in denen jeweils die Abtastratenerhöhung durch einen Abtastratenerhöher und die anschließende Dekorrelation durch ein Dekorrelationsfilter vorgenommen werden. Da das Eingangssignal und das Referenzsignal durch funktionsgleiche Strukturen, d.h. z.B. durch Interpolationseinrichtungen gleicher Bauart, verarbeitet werden, kann der Aufwand für die technische Realisierung des Verfahrens gering gehalten werden.

Vorteilhaft wird das Differenzsignal einer Dezimatoreinrichtung zugeführt, in der die Kompensation der Dekorrelation durch ein Ausgleichsfilter und die anschließende Abtastratenverringerung durch einen Abtastratenerniedriger vorgenommen werden.

In einer vorteilhaften Weiterbildung der Erfindung fügt der Abtastratenerhöher zwischen aufeinanderfolgenden, den ursprünglichen Abtastzeitpunkt zugeordneten Abtastwerten M-1 Zwischenwerte ein. Die Zwischenwerte können gleich Null sein. Vorteilhaft blendet der Abtastratenerniedriger die M-1 Abtastwerte des Differenzsignals aus, die zwischen den ursprünglichen Abtastzeitpunkten liegen.

In einer weiteren Ausgestaltung der Erfindung enthält das erste und das zweite Dekorrelationsfilter jeweils M Dekorrelationsteilfilter, die mit der niedrigen Abtastrate betrieben werden können und deren Übertragungsfunktionen $H'_i$ die Übertragungsfunktion $H'$ des ersten und des zweiten Dekorrelationsfilter nach folgender Beziehung ergeben

$$(1) \qquad H'(z) = \sum_{i=0}^{M-1} z^{-i} H'_i(z^M)$$

mit $= e^{j\omega T}$, worin $\omega$ die Kreisfrequenz, T eine der hohen Abtastrate entsprechende kurze Abtastperiode und j die imaginäre Einheit sind.

Diese Maßnahme ist insbesondere dann von praktischem Nutzen, wenn die M-1 zugeführten Abtastwerte gleich Null sind. Obgleich die Dekorrelationsteilfilter mit niedriger Abtastrate arbeiten, können durch diese Weiterbildung der Erfindung die mit der hohen Abtastrate abgetasteten Signale in dem ersten und dem zweiten Dekorrelationsfilter verarbeitet werden. Die M dekorrelierten Abtastwerte des Eingangssignals und des Referenzsignals innerhalb einer der niedrigen Abtastrate entsprechenden langen Abtastperiode sind jeweils im wesentlichen durch die Übertragungsfunktion eines der M Dekorrelationsteilfilter gegeben. Da sich die Übertragungsfunktion $H'$ des ersten und des zweiten Dekorrelationsfilters jeweils aus den Übertragungfunktionen $H'_i$ der einzelnen Dekorrelationsteilfilter zusammensetzt, können die Übertragungseigenschaften der Dekorrelationsfilter beispielsweise durch Austauschen oder Ändern einzelner Dekorrelationsteilfilter der jeweiligen Anwendung angepaßt werden. Dies eröffnet dem beschriebenen Verfahren einen breiten Anwendungsbereich.

Vorteilhaft enthält des Ausgleichsfilter ein erstes Ausgleichsteilfilter, das mit der niedrigen Abtastrate betrieben wird und eine Übertragungsfunktion $H_0''$ hat, für welche die Beziehung

$$(2) \qquad H_0''(z^M) \cdot H_0'(z^M) = z^{-\alpha}$$

zumindest näherungsweise erfüllt ist, worin $\alpha$ ein nicht negative Konstante und $H_0'$ die Übertragungsfunktion des ersten Dekorrelationsteilfilters des ersten und des zweiten Dekorrelationsfilters bezeichnet, das die den ursprünglichen Abtastzeitpunkt zugeordneten Abtastwerte ermittelt. Das erste Dekorrelationsteilfilter und das erste Ausgleichsfilter können Durchgangsfilter sein, deren Übertragungsfunktionen $H_0'$ und $H_0''$ die Beziehung

$$(3) \qquad H_0'(z^M) = H_0''(z^M) =$$

erfüllen. Die Abstimmung des Durchgangsfilters auf das erste und das zweite Dekorrelationsfilter wird auf diese Weise auf eine Abstimmung des ersten Ausgleichsteilfilters auf das erste Dekorrelationsteilfilter reduziert. Genügen die aufeinander abgestimmten Übertragungsfunktionen $H_0'$ und $H_0''$ der Bedingung (3), so können einfache Durchgangsfilter verwendet werden, welche die Signale ungefiltert, d.h. ohne Veränderung der Abtastwerte, übertragen.

Das Ausgleichsfilter kann weitere M-1 Ausgleichsteilfilter enthalten, die mit der niedrigen Abtastrate betrieben werden und deren Übertragungsfunktionen $H_i''$ mit der Übertragungsfunktion $H_0''$ des ersten Ausgleichsteilfilters die Übertragungsfunktionen $H''$ des Ausgleichsfilters nach der Beziehung

$$(4) \qquad H''(z) = \sum_{i=0}^{M-1} z^{-i} H_i''(z^M)$$

ergeben. Diese Weiterbildung der Erfindung kann in Anwendungen von Vorteil sein, in denen die entsprechenden Signale nicht den oben erläuterten Anforderungen hinsichtlich der Rückgewinnung der Sprachinformation unterliegen.

In einer weiteren Ausgestaltung der Erfindung ist vorgesehen, daß die M Dekorrelationsteilfilter des ersten und des zweiten Dekorrelationsfilters jeweils parallel geschaltet sind, ihnen das mit der kurzen Abtastperiode abgetastete Eingangssignal bzw. das Referenzsignal zugeführt wird und ihre Ausgänge über eine Reihenanordnung miteinander verbunden sind, in der M-1 Verzögerungsglieder, die jeweils eine der kurzen Abtastperiode entsprechende Signalverzögerung bewirken, und M Additionsglieder in alternierender Folge angeordnet sind. Mit diesem Aufbau des ersten und des zweiten Dekorrelationsfilters läßt sich die Übertragungsfunktion $H'$, wie sie in der Beziehung (1) angegeben ist, auf besonders einfache Weise realisieren.

Vorteilhaft ist das adaptive Digitalfilter ausgestattet mit einer Verzögerungskette von N-1 Verzögerungsgliedern, die das dekorrelierte Eingangssignal jeweils um die der niedrigen Abtastrate entsprechende Abtastperiode verzögern, einer von der Verzögerungskette abzweigenden Parallelanordnung von N Multiplikationsgliedern, die durch die Adaptionseinheit jeweils mit einem der N Filterkoeffizienten angesteuert werden, und mit einer Reihenanordnung von N-1 Additionsgliedern, welche die Ausgänge der Multiplikationsglieder miteinander verknüpft und das Kompensationssignal an ein weiteres Additionsglied ausgibt. Diesem Additionsglied wird das dekorrelierte Referenzsignal zugeführt. Das Additionsglied ermittelt aus dem Kompensationssignal und dem Referenzsignal das Differenzsignal und führt dieses der Adaptionseinheit des adaptiven Digitalfilters zu. In jedem Adaptionsschritt der Koeffizientenadaption, die, wie oben erläutert, mit der hohen Abtastrate vollzogen wird, werden im Rahmen des LMS-Algorithmus M Abtastwerte des dekorrelierten Eingangssignals verwendet. Durch die Verzögerungskette mit ihren N-1 Verzögerungsgliedern werden in jeweils einem Adaptionsschritt nur solche Abtastwerte des Eingangssignals verarbeitet, deren Abtastzeitpunkte der niedrigen Abtastrate entsprechen, d.h. deren zeitlicher Abstand durch die lange Abtastperiode gegeben ist. Insbesondere werden die Abtastwerte des Eingangssignals, die zu den ursprünglichen Abtastzeitpunkten auftreten, innerhalb eines Adaptionsschrittes nicht gleichzeitig mit Abtastwerten verarbeitet, die durch die Abtastratenerhöhung erzeugt worden sind. Wird insbesondere als erstes Dekorrelationsteilfilter der Dekorrelationsfilter ein Durchgangsfilter verwendet, so geht bei jedem M-ten Adaptionsschritt das Eingangssignal in seiner ursprünglichen Form, d.h. nicht interpoliert, in die Koeffizientenadaption ein. Dadurch wird der Implentierungsaufwand unter Beibehaltung des guten Konvergenzverhaltens reduziert.

Gemäß einem weiteren Aspekt der Erfindung ist eine adaptive Digitalfiltereinrichtung gemäß Anspruch 15 vorgesehen, mit der das erfindungsgemäße Verfahren durchgeführt werden kann.

Weitere vorteilhafte Weiterbildungen der Erfindung sind Gegenstand der Unteransprüche sowie der folgenden Beschreibung.

Die Erfindung wird im folgenden an Hand der Figuren näher erläutert. Darin zeigen:

Figur 1    ein Blockdiagramm eines sprachgesteuerten Ansagesystems mit einer adaptiven Digitalfiltereinrichtung,

Figur 2    ein Blockdiagramm einer Interpolationseinrichtung und einer Dezimatoreinrichtung der adaptiven Digitalfiltereinrichtung,

Figur 3    ein Blockdiagramm der Interpolationseinrichtung und der Dezimatoreinrichtung in einer speziellen Ausführungsform,

Figur 4    ein Blockdiagramm eines nichtrekursiven adaptiven Digitalfilters der Digitalfiltereinrichtung,

Figur 5    eine Schaltungsanordnung der Interpolationseinrichtung und der Dezimatoreinrichtung der Digitalfiltereinrichtung in einem Ausführungsbeispiel,

Figur 6    den Frequenzverlauf der Dämpfung eines mit der Digitalfiltereinrichtung nach Fig. 5 verarbeiteten Ansagesignals,

Figur 7    den zeitlichen Verlauf der mittleren Dämpfung des Echopfades und der Abweichung eines aktuellen Satzes von Filterkoeffizienten von einem optimalen Satz für eine bekannte Digitalfiltereinrichtung,

Figur 8    den zeitlichen Verlauf der mittleren Dämpfung des Echopfades und der Abweichung des aktuellen Satzes von Filterkoeffizienten von dem optimalen Satz für ein Ausführungsbeispiel der Digitalfiltereinrichtung nach Figur 5 und

Figur 9    den zeitlichen Verlauf der mittleren Dämpfung des Echopfades und der Abweichung des aktuellen Satzes von Filterkoeffizienten von dem optimalen Satz für ein weiteres Ausführungsbeispiel der Digitalfiltereinrichtung nach Figur 5.

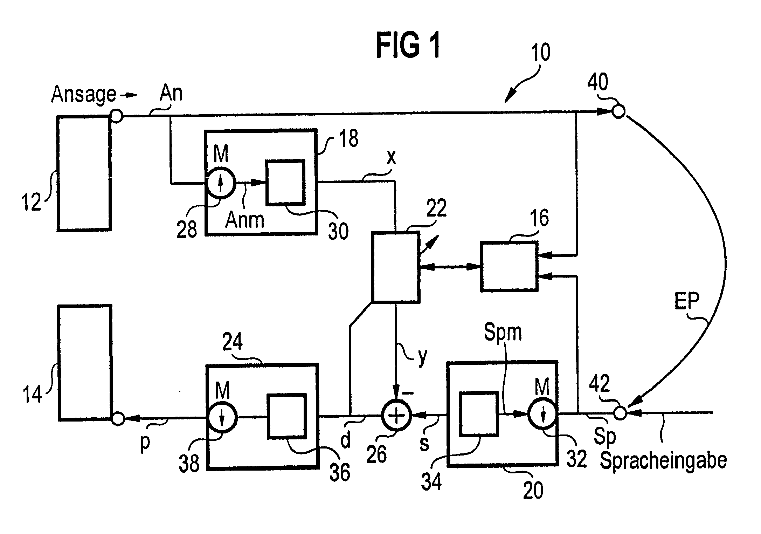

Die erfindungsgemäße adaptive Digitalfiltereinrichtung wird im folgenden am Beispiel eines sprachgesteuerten Ansagesystems erläutert. In Figur 1 ist ein sprachgesteuertes Ansagesystem 10 dargestellt, das es dem Benutzer ermöglicht, eine Spracheingabe während einer Ansage vorzunehmen. Das Ansagesystem 10 enthält neben einer Ansageeinrichtung 12 und einer Spracherkennungseinrichtung 14 als funktionswesentliche Komponenten eine Detektoreinrichtung 16 und eine adaptive Digitalfiltereinrichtung. In der Digitalfiltereinrichtung sind eine erste Interpolationseinrichtung 18, eine zweite Interpolationseinrichtung 20, ein adaptives Digitalfilter 22, im folgenden im Hinblick auf seine Verwendung auch als Echounterdrückungsfilter bezeichnet, eine Dezimatoreinrichtung 24 und ein Additionsglied 26 enthalten. Die erste Interpolationseinrichtung 18 enthält in Reihe geschaltet einen ersten Abtastratenerhöher 28 und ein erstes digitales Dekorrelationsfilter 30. Die zweite Interpolationseinrichtung 20 ist ebenso aufgebaut wie die erste Interpolationseinrichtung 18 und enthält somit in Reihe geschaltet einen zweiten Abtastratenerhöher 32 und ein zweites Dekorrelationsfilter 34. Der erste und der zweite Abtastratenerhöher 28, 32 und das erste und das zweite Dekorrelationsfilter 30, 34 können jeweils identische Komponenten sein. Die Dezimatoreinrichtung 24 besteht aus einem digitalen Ausgleichsfilter 36 und einem nachfolgenden Abtastratenerniedriger 38.

Einer Ansage des Ansagesystems liegt ein digitales Ansagesignal An zugrunde, das in bekannter Weise durch einen D-A-Wandler (nicht dargestellt) in ein analoges und dann für den Benutzer hörbares Signal gewandelt wird. Die Ansage wird dem Benutzer über einen Ausgang 40 des Ansagesystems 10 zugeführt. Aus einer Spracheingabe des Benutzers wird durch A-D-Wandlung eines der Spracheingabe entsprechenden, analogen Signals ein digitales Spracheingabesignal Sp erzeugt, das dem Ansagesystem 10 über einen Eingang 42 zugeführt wird. Das Ansagesignal An und das Spracheingabesignal Sp sind jeweils eine Folge von Abtastwerten, deren zeitlicher Abstand durch eine vorgegebene erste Abtastperiode festgelegt ist. Im Hinblick auf die später erläuterte Abtastratenerhöhung wird die erste vorgegebene Abtastperiode im folgenden als lange Abtastperiode und entsprechend die Abtastrate des Ansagesignals An und des Spracheingabesignals Sp als niedrige Abtastrate bezeichnet. Abtastwerte, deren Abtastzeitpunkte durch die niedrige Abtastrate gegeben sind, werden im weiteren auch "regulär" genannt.

Das Ansagesignal An und das Spracheingabesignal Sp werden der Detektoreinheit 16 zugeführt, die ein gleichzeitiges Auftreten von Ansage und Spracheingabe feststellt. Die Detektoreinrichtung 16 steuert das Echounterdrückungsfilter 22 an und deaktiviert die später erläuterte Koeffizientenadaption, wenn Ansage und Spracheingabe gleichzeitig auftreten. Auf diese Weise ist gewährleistet, daß die Adaption des Echounterdrückungsfilters 22 nur dann erfolgt, wenn die Ansage allein auftritt.

Wie eingangs erwähnt, sind das Ansagesignal An und das Spracheingabesignal Sp mit der vorgegebenen niedrigen Abtastrate abgetastet. Die erste Interpolationseinrichtung 18 und die zweite Interpolationseinrichtung 20 haben die Funktion, aus dem Ansagesignal An bzw. dem Spracheingabesignal Sp ein Signal zu erzeugen, dessen Abtastrate erhöht ist und dessen Abtastwerte zudem wenigstens bis zu einem gewissen Grad dekorreliert sind. Das Ansagesignal An, das durch die erste Interpolationseinrichtung 18 in seiner Abtastrate erhöht und zudem dekorreliert wird, wird im folgenden als interpoliertes Ansagesignal x, seine Abtastrate als hohe Abtastrate bezeichnet. Entsprechend wird das Spracheingabesignal Sp, das das zweite Interpolationsteilfilter durchlaufen hat, als interpoliertes Spracheingabesignal s bezeichnet.

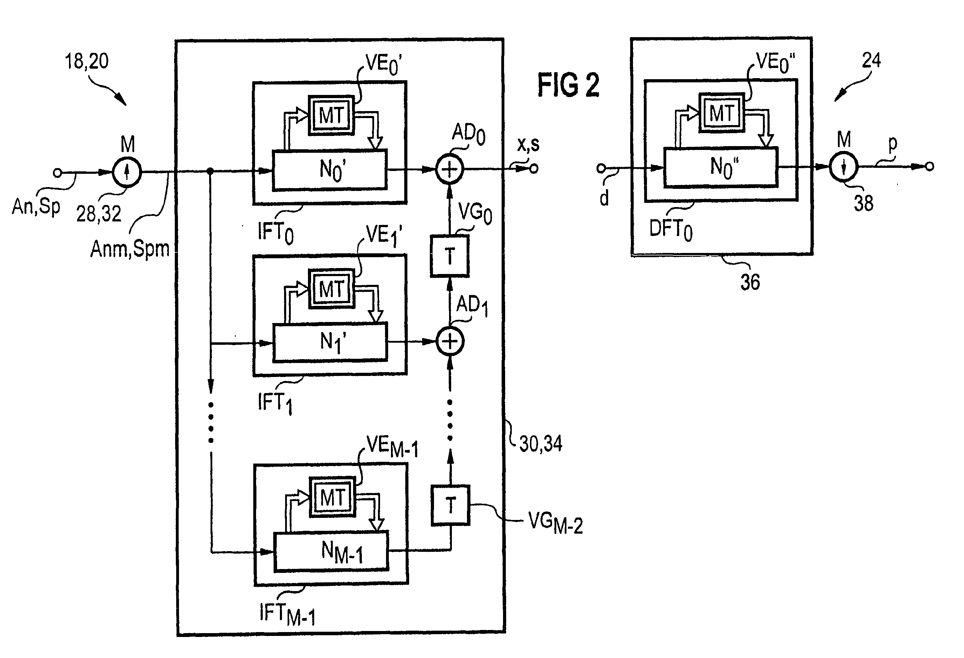

Der erste Abtastratenerhöher 28 erhöht die Abtastrate bzw. verringert die Abtastperiode des Ansagesignals An um einen vorgegebenen Faktor M, indem er zwischen aufeinanderfolgenden regulären Abtastwerten des Ansagesignals An M-1 Null-Werte einfügt. Ist die hohe Abtastrate mit F und damit die kurze Abtastperiode mit T angesetzt, so ist die niedrige Abtastrate durch den Wert des Quotienten aus F und M und die lange Abtastperiode durch den Wert des Produktes aus M und T gegeben. Ein auf eben erläuterte Weise mit Null-Werten versehenes, modifiziertes Ansagesignal, im folgenden Anm genannt, wird in dem ersten Dekorrelationsfilter 30 weiterverarbeitet. Die Übertragungsfunktion H' des ersten Dekorrelationsfilters 30 ist in Abhängigkeit der Ansage so angesetzt, daß die Abtastwerte des interpolierten Ansagesignals x zumindest teilweise dekorreliert sind. In gleicher Weise erzeugt die zweite Interpolationseinrichtung 20 aus dem Spracheingabesignal Sp zunächst ein modifiziertes Spracheingabesignal, im folgenden Spm genannt, bei dem zwischen aufeinanderfolgenden, regulären Abtastwerten M-1 Null-Werte eingefügt sind, und aus diesem das interpolierte Spracheingabesignal s, dessen Abtastrate um den Faktor M erhöht ist und dessen Abtastwerte ebenso dekorreliert sind, wie die Abtastwerte des interpolierten Ansagesignals x. Die Funktionsweise der Interpolationseinrichtungen 18 und 20 wird später unter Bezugnahme auf die Figuren 2 bis 9 erläutert.

Das Echounterdrückungsfilter 22 hat die Aufgabe, die Spracheingabe von einem Ansageecho zu befreien, das über einen Echopfad EP vom Ausgang 40 zum Eingang 42 des Ansagesystems 10 übertragen wird und dort in das zu verarbeitende Spracheingabesignal Sp eingeht. Um das Ansageecho aus dem Spracheingabesignal Sp zu entfernen, werden die Übertragungseigenschaften des Echopfades EP, d.h. seine Übertragungsfunktion, von dem Echounterdrückungsfilter 22 in einem schnell konvergierenden Adaptionsverfahren nachgebildet. Dem Echounterdrückungsfilter 22 wird das interpolierte Ansagesignal x zugeführt. Das Echounterdrückungsfilter 22 erzeugt in noch zu beschreibender Weise ein Kompensationssignal y mit der vorgegebenen hohen Abtastrate. An dem Additionsglied 26 wird das Kompensationssignal y von dem interpolierten Spracheingabesignal s abgezogen und ein Differenzsignal d an die Dezimatoreinrichtung 24 weitergeleitet.

In der Dezimatoreinrichtung 24 wird das Differenzsignal d durch das Ausgleichsfilter 36 in noch zu beschreibender Weise gefiltert und dem Abtastratenerniedriger 38 zugeführt. Dieser verringert die Abtastrate bzw. verlängert die Abtastperiode des gefilterten Differenzsignals d um den Faktor M, indem er die M-1 Zwischenwerte zwischen den regulären Abtastwerten ausblendet. Der Abtastratenerniedriger 38 leitet schließlich ein auf diese Weise ermitteltes Nutzsignal p an die Spracherkennungseinrichtung 14 weiter. Das Nutzsignal p ist wie das Ansagesignal An und das Spracheingabesignal Sp mit der vorgegebenen niedrigen Abtastrate abgetastet, d.h. der zeitliche Abstand zwischen zwei aufeinanderfolgenden Abtastwerten ist gleich der vorgegebenen langen Abtastperiode. Der Spracherkennungseinrichtung 14 steht mit dem Nutzsignal p ein digitales Signal der von dem Ansageecho befreiten Spracheingabe zur Verfügung. In der Spracherkennungseinrichtung 14 kann in bekannter Weise der relevante Nachrichteninhalt aus der Spracheingabe gewonnen werden.

Die erste Interpolationseinrichtung 18 und die zweite Interpolationseinrichtung 20 können für die Verwendung in dem Ansagesystem 10 nach Fig. 1 identisch aufgebaut sein. Aus diesem Grunde wird im folgenden an Hand der Figuren 2, 3 und 5 der Aufbau und die Funktionsweise der ersten Interpolationseinrichtung 18 erläutert, ohne nochmals auf die zweite Interpolationseinrichtung 20 einzugehen. Für die zweite Interpolationseinrichtung 20 gilt das für die erste Interpolationseinrichtung 18 Erläuterte entsprechend. In den Fig. 2, 3 und 5 sind zusätzlich die Bezugszeichen der zweiten Interpolationseinrichtung 20 eingetragen.

In Figur 2 sind die erste Interpolationseinrichtung 18 und die Dezimatoreinrichtung 24 dargestellt. Wie eingangs erwähnt, ist die erste Interpolationseinrichtung 18 durch das erste Dekorrelationsfilter 30 und den vorgeschalteten Abtastratenerhöher 28 gegeben. Der Abtastratenerhöher 28 erhöht die Abtastrate des Ansagesignals An um den vorgegebenen Faktor M, indem er M-1 Null-Werte zwischen zwei aufeinanderfolgenden regulären Abtastwerten einfügt, und erzeugt so das modifizierte Ansagesignal Anm. Das erste Dekorrelationsfilter 30 enthält M parallel angeordnete Dekorrelationsteilfilter $IFT_0$ bis $IFT_{M-1}$, denen das modifizierte Ansagesignal Anm zugeführt wird. Jedes der Dekorrela-

tionsteilfilter $IFT_0$ bis $IFT_{M-1}$ kann in "gedächtnislose" Netzwerke $N_0'$ bis $N'_{M-1}$ und Verzögerungseinheiten $VE'_0$ bis $VE'_{M-1}$ unterteilt werden. Unter gedächtnislosen Netzwerken sind Netzwerke zu verstehen, die Additionsglieder und Multiplikationsglieder, aber keine Verzögerungsglieder enthalten können.

Die Verzögerungseinheiten $VE'_0$ bis $VE'_{M-1}$ verzögern das modifizierte Ansagesignal Anm um die lange Abtastperiode oder ein Vielfaches der langen Abtastperiode. Die lange Abtastperiode ist das M-fache der kurzen Abtastperiode T. Die Ausgänge der Interpolationsteilfilter $IFT_0$ bis $IFT_{M-1}$ sind über eine Reihenanordnung miteinander verbunden, in der M-1 Verzögerungsglieder $VG_0$ bis $VG_{M-2}$ und M Additionsglieder $AD_0$ bis $AD_{M-1}$ in alternierender Folge angeordnet sind. Die Ausgänge der ersten M-2 Dekorrelationsteilfilter $IFT_0$ bis $IFT_{M-2}$ sind jeweils mit dem entsprechenden Additionsglied $AD_0$ bis $AD_{M-2}$ verbunden, während der Ausgang des letzten Dekorrelationsteilfilters $IFT_{M-1}$ auf das Verzögerungsglied $VG_{M-2}$ geschaltet ist. Die Verzögerungsglieder $VG_0$ bis $VG_{M-2}$ sorgen jeweils für eine der kurzen Abtastperiode T entsprechende Signalverzögerung. Über das erste Additionsglied $AD_0$ gibt das erste Dekorrelationsfilter 30 das interpolierte, d.h. das in der Abtastrate erhöhte und zumindest teilweise dekorrelierte Ansagesignal x aus.

Der eben erläuterte Aufbau des ersten Dekorrelationsfilters 30 spiegelt sich in der Beziehung (1) wieder, in der angegeben ist, wie sich die Übertragungsfunktion H' des ersten Dekorrelationsfilters aus den Übertragungsfunktionen $H'_i$ der Dekorrelationsteilfilter $IFT_0$ bis $IFT_{M-1}$ zusammensetzt. Das mit der hohen Abtastrate abgetastete, modifizierte Ansagesignal Anm kann demnach in dem ersten Dekorrelationsfilter 30 im wesentlichen mit der niedrigen Abtastrate verarbeitet werden, da die Dekorrelationsteilfilter $IFT_0$ bis $IFT_{M-1}$ auf der niedrigen Abtastrate betrieben werden. Jede der zwischen zwei regulären Abtastwerten eingefügten M-1 Null-Werte wird von einem der Dekorrelationsteilfilter $IFT_1$ bis $IFT_{M-1}$ entsprechend der zugehörigen Übertragungsfunktion $H'_i$ in einen Zwischenwert umgesetzt, so daß aus dem durch das Einfügen der Null-Werte modifizierten Ansagesignal Anm das interpolierte Ansagesignal x erzeugt wird. Der Grad der gewünschten Dekorrelation kann in Abhängigkeit des bekannten Ansagesignals An über die Übertragungsfunktionen $H'_i$ der Dekorrelationsteilfilter $IFT_0$ bis $IFT_{M-1}$ eingestellt werden.

In Figur 2 ist neben der ersten Interpolationseinrichtung 18 die Dezimatoreinrichtung 24 dargestellt, die aus dem Ausgleichsfilter 36 und dem nachfolgenden Abtastratenerniedriger 38 besteht. Das Ausgleichsfilter 36 enthält in diesem Ausführungsbeispiel nur ein einziges Ausgleichsteilfilter $DFT_0$, das wie die Dekorrelationsteilfilter $IFT_0$ bis $IFT_{M-1}$ der Dekorrelationsfilter 30 und 34 in ein gedächtnisloses Netzwerk $N_0''$ und eine Verzögerungseinheit $VE_0''$ unterteilt werden kann. Die durch die Verzögerungseinheit $VE_0''$ hervorgerufenen Signalverzögerungen entsprechen der langen Abtastperiode, d.h. dem M-fachen der kurzen Abtastperiode T, oder einem Vielfachen davon. Auch das Ausgleichsteilfilter $IFT_0$ wird somit auf der niedrigen Abtastrate betrieben.

Die Übertragungsfunktion $H_0''$ des Ausgleichsfilters 36 ist mit der Übertragungsfunktion $H_0'$ des ersten Dekorrelationsteilfilters $IFT_0$ der Dekorrelationsfilter 30 und 34 über die Beziehung (2) verknüpft. Nach Gleichung (2) werden für die regulären Abtastwerte des Differenzsignals d, die den ursprünglichen Abtastwerten des Ansagesignals An bzw. des Spracheingabesignals Sp entsprechen, die Signalveränderungen kompensiert, die durch die Übertragung des ersten Dekorrelationsteilfilters $IFT_0$ der Dekorrelationsfilter 30, 34 hervorgerufen worden sind. Durch den Abtastratenerniedriger 38 werden die zwischen zwei aufeinanderfolgenden, regulären Abtastwerten auftretenden M-1 Zwischenwerte des Differenzsignals d ausgeblendet, so daß am Ausgang der Dezimatoreinrichtung 24 das mit der niedrigen Abtastrate abgetastete Nutzsignal p zur Verfügung steht. Die Dezimatoreinrichtung 24 sorgt demnach dafür, daß die Abtastwerte des Nutzsignals p durch die Maßnahmen zur Abtastratenerhöhung und Dekorrelation nicht verfälscht werden, d.h. daß sich das Spracheingabesignal abgesehen von der angestrebten Echounterdrückung nach erfolgter Interpolation und anschließender Abtastratenverringerung so darstellt wie vorher.

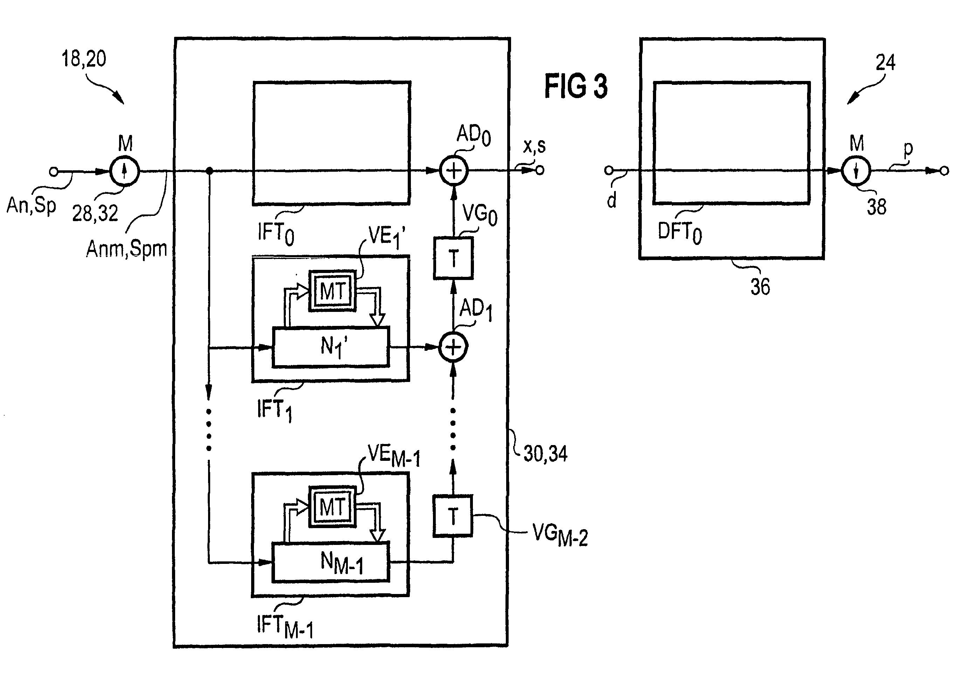

In Figur 3 sind die erste bzw. zweite Interpolationseinrichtung 18 bzw. 20 und die entsprechende Dezimatoreinrichtung 24 für ein Ausführungsbeispiel dargestellt, bei dem das erste Dekorrelationsteilfilter $IFT_0$ ein einfaches Durchgangsfilter ist, welches das modifizierte Ansagesignal Anm bzw. Spracheingabesignal Spm dem Additionsglied $AD_0$ ohne Veränderungen zuführt. In diesem Fall ist auch das Ausgleichsteilfilter $DFT_0$ ein einfaches Durchgangsfilter. Nach Beziehung (3) sind die Übertragungsfunktion $H_0'$ des ersten Dekorrelationsteilfilters $IFT_0$ und die Übertragungsfunktion $H_0''$ des Ausgleichsteilfilters $DFT_0$ gleich Eins.

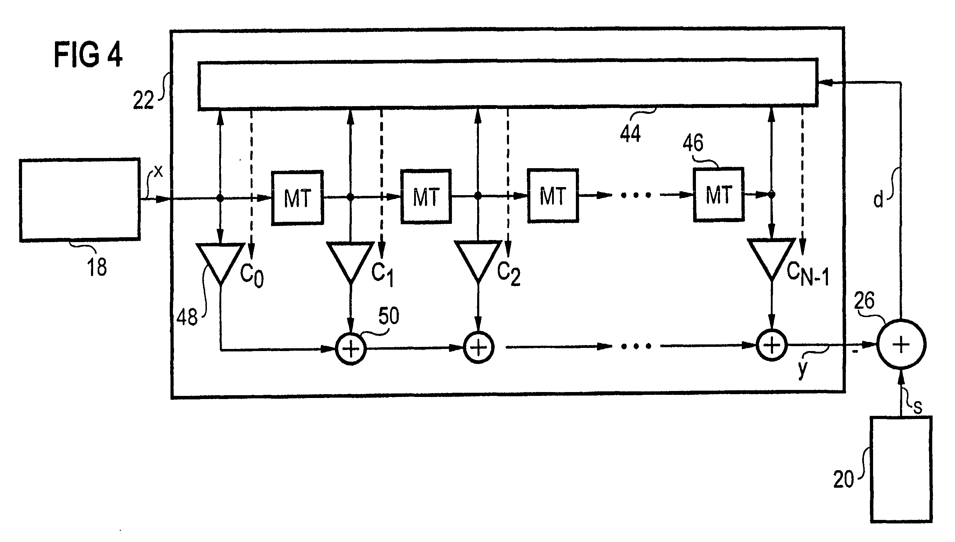

Der Aufbau und die Funktionsweise des adaptiven Echounterdrückungsfilters 22 wird im folgenden an Hand der Figur 4 näher erläutert. Das Echounterdrückungsfilter 22 erzeugt aus dem interpolierten Ansagesignal x, das ihm von der ersten Interpolationseinrichtung 18 zugeführt wird, das Kompensationssignal y. Das Kompensationssignal y basiert auf N Filterkoeffizienten $c_0$ bis $c_{N-1}$, die eine Adaptionseinheit 44 des Echounterdrückungsfilters 22 liefert. Die Adaptionseinheit 44 ermittelt die N Filterkoeffizienten $c_0$ bis $c_{N-1}$ nach dem LMS-Algorithmus in Abhängigkeit des Differenzsignals d, das in dem Additionsglied 26 aus dem Kompensationssignal y und dem interpolierten Spracheingabesignal s gebildet wird.

Das Echounterdrückungsfilter 22 enthält eine Verzögerungskette mit N-1 Verzögerungsgliedern 46, die das interpolierte Ansagesignal x jeweils um die lange Abtastperiode, d.h. um das M-fache der kurzen Abtastperiode T, verzögern. Von der Verzögerungskette abzweigend sind N Multiplikationsglieder 48 parallel angeordnet, die durch die Adaptionseinheit 44 jeweils mit einem der N Filterkoeffizienten $c_0$ bis $c_{N-1}$ angesteuert werden. Die Ausgänge der Multiplikationsglieder 48 sind über eine Reihenanordnung von N-1 Additionsgliedern 50 miteinander verknüpft. Das letzte Additionsglied der Reihenanordnung, das mit dem über den Filterkoeffizienten $c_{N-1}$ angesteuerten Multiplikationsglied verbunden ist, leitet das Kompensationssignal y dem Additionsglied 26 zu.

Die Filterkoeffizienten $c_0$ bis $c_{N-1}$ werden in der Adaptionseinheit 44 nach dem LMS-Algorithmus bestimmt. Dazu wird in der Zeit, in der die Ansage allein auftritt, d.h. in der keine "double talking"-Bedingungen herrschen, im wesentlichen das Betragsquadrat des Differenzsignals d, das die Abweichung des Kompensationssignals y von dem interpolierten Spracheingabesignal s angibt, durch Anpassen der Filterkoeffizienten $c_0$ bis $c_{N-1}$ minimiert. Da die Verzögerungsglieder 46 der Verzögerungskette jeweils eine Signalverzögerung entsprechend der langen Abtastperiode hervorrufen, gehen in einen einzelnen Abtastwert des Kompensationssignals y nur solche mit den Filterkoeffizienten $c_0$ bis $c_{N-1}$ gewichteten Abtastwerte des interpolierten Eingangssignals x ein, deren zeitlicher Abstand durch die lange Abtastperiode gegeben ist. Innerhalb einer langen Abtastperiode werden so in der Adaptionseinheit 44 M Adaptionsschritte vollzogen. Werden beim ersten Adaptionsschritt innerhalb der langen Abtastperiode nur reguläre Abtastwerte des interpolierten Eingabesignals x berücksichtigt, so gehen bei den folgenden M-1 Adaptionsschritten nur Abtastwerte in die Bestimmung der Filterkoeffizienten $c_0$ bis $c_{N-1}$ ein, die durch die Abtastratenerhöhung und die Dekorrelation des Eingangssignals An erzeugt worden sind. Entsprechendes gilt für das interpolierte Spracheingabesignal s.

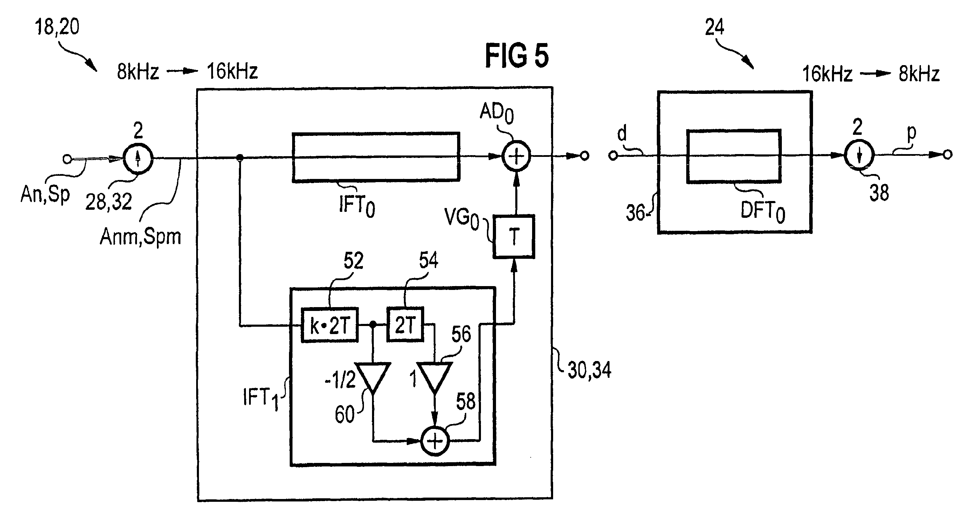

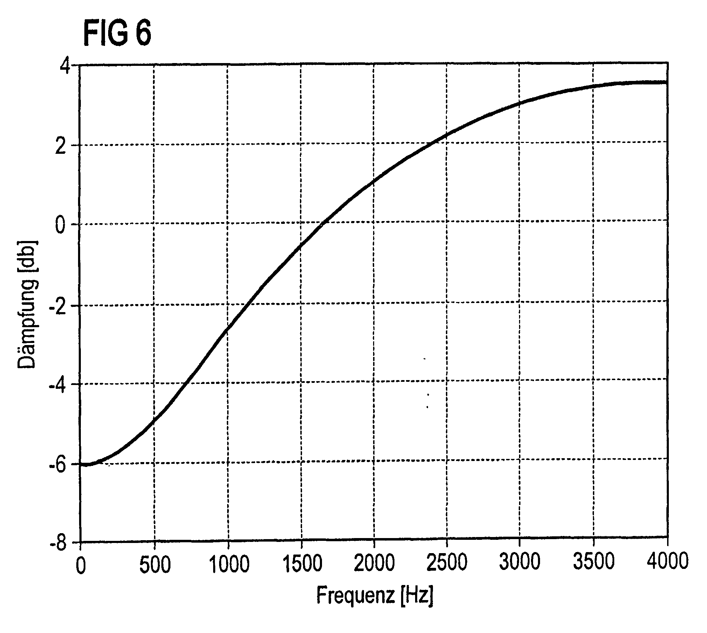

Im folgenden wird die Erfindung an Hand konkreter Ausführungsbeispiele erläutert. Zudem werden an einem Beispiel ihre Vorteile gegenüber dem Stand der Technik illustriert. In Figur 5 sind die erste Interpolationseinrichtung 18 und die Dezimatoreinrichtung 24 für ein Beispiel dargestellt, in dem eine Abtastratenerhöhung um den Faktor M gleich zwei vorgenommen wird. Wie schon bei der Erläuterung der Figuren 2 und 3 erwähnt, ist die zweite Interpolationseinrichtung 20 ebenso aufgebaut wie die erste Interpolationseinrichtung 18, so daß das im folgenden hinsichtlich des Ansagesignals An Erläuterte entsprechend für das Spracheingabesignal Sp gilt. Die Interpolationseinrichtung 18 hat die Aufgabe, das Ansagesignal An zwischen aufeinanderfolgenden regulären Abtastwerten derart zu interpolieren, daß die in Figur 6 dargestellte Färbung der Ansage möglichst weitgehend kompensiert wird. In Figur 6 ist der Frequenzverlauf der Dämpfung aufgetragen, wie er sich typischerweise für menschliche Sprache und damit für die Ansage und die Spracheingabe darstellt. Der in Fig. 6 gezeigte Verlauf zeigt die Eigenschaften einer sogenannten Tiefpaß-Färbung.

Da der Faktor M in dem Ausführungsbeispiel nach Figur 5 gleich zwei ist, enthält das Dekorrelationsfilter 18, 20 die beiden Dekorrelationsteilfilter $IFT_0$ und $IFT_1$. Das erste Dekorrelationsteilfilter $IFT_0$ ist als einfaches Durchgangsfilter ausgebildet, dessen Übertragungsfunktion $H'_0$ durch Beziehung (3) gegeben ist. Das Ausgleichsfilter 36 enthält nur ein Ausgleichsteilfilter $DFT_0$, das entsprechend der Beziehung (3) ebenfalls als Durchgangsfilter ausgebildet ist. Das erste Dekorrelationsteilfilter $IFT_1$ enthält ein Verzögerungsglied 52, das eine k-fache Signalverzögerung der zweifachen kurzen Abtastperiode T hervorruft. k ist dabei eine ganze, nichtnegative Zahl. Dem Verzögerungsglied 52 schließt sich ein Verzögerungsglied 54, das eine Signalverzögerung der zweifachen kurzen Abtastperiode erzeugt, und ein Multiplikationsglied 56 an, dessen Ausgang auf den Eingang eines Additionsgliedes 58 führt. Zwischen den Verzögerungsgliedern 52 und 54 ist abzweigend ein Multiplikationsglied 60 vorgesehen, dessen Ausgang ebenfalls auf das Additionsglied 58 geführt ist. Für das nach Figur 6 spezifizierte Ansagesignal ist der Multiplikationsfaktor des Multiplikationsgliedes 56 mit 1 und der Multiplikationsfaktor des Multiplikationsgliedes 60 mit -1/2 angesetzt. Die Übertragungsfunktion $H'_1$ des in Fig. 5 dargestellten Dekorrelationsteilfilters ist geeignet, die in Fig. 6 dargestellte Färbung der Ansage bzw. der Spracheingabe weitgehend aufzuheben. Die Effizienz, mit der dies möglich ist, hängt von der Konstante k ab, wie weiter unten gezeigt wird. Die Multiplikationsglieder 56, 60 sind in den Figuren 2 und 3 als gedächtnisloses Netzwerk $N_1'$ bezeichnet, während die Verzögerungsglieder 52, 54 in diesen Figuren der Verzögerungseinheit $VE_1'$ entsprechen.

Das Ansagesignal An bzw. das Spracheingabesignal Sp wird zunächst dem Abtastratenerhöher 28 bzw. 32 zugeführt, der das modifizierte, in der Abtastrate erhöhte Ansagesignal Anm bzw. Spracheingabesignal Spm erzeugt. Bei dem erläuterten Beispiel können das Ansagesignal An und das Spracheingabesignal Sp mit einer der niedrigen Abtastrate entsprechenden Abtastfrequenz von z.B. 8 kHz abgetastet sein. Der Abtastratenerhöher 28 bzw. 32 erhöht somit die Abtastfrequenz auf 16 kHz. Das modifizierte Ansagesignal Anm bzw. Spracheingabesignal Spm werden nun in einem ersten Verarbeitungszweig durch das erste Dekorrelationsteilfilter $IFT_0$ und in einem zweiten Verarbeitungszweig durch das zweite Dekorrelationsfilter $IFT_1$ verarbeitet. An dem Additionsglied $AD_0$ werden die beiden Ausgangssignale des ersten Dekorrelationsteilfilters $IFT_0$ und des zweiten Dekorrelationsteilfilters $IFT_1$, die durch das Verzögerungsglied $VG_0$ um eine kurze Abtastperiode zeitlich zueinander verschoben sind, addiert und als interpoliertes Ansagesignal x bzw. als interpoliertes Spracheingabesignal s ausgegeben.

Das Differenzsignal d wird von dem Ausgleichsfilter 36 unverändert an den Abtastratenerniedriger 38 weitergeleitet. Dieser führt in diesem Ausführungsbeispiel die notwendige Halbierung der Abtastfrequenz von 16 kHz auf 8 kHz durch, indem er jeden zweiten Abtastwert des Differenzsignals d ausblendet. Das auf diese Weise erzeugte Nutzsignal p, das wie das Ansagesignal An und das Spracheingabesignal Sp mit der Abtastfrequenz von 8 kHz abgetastet ist, wird der Spracherkennungseinheit 14 zugeführt.

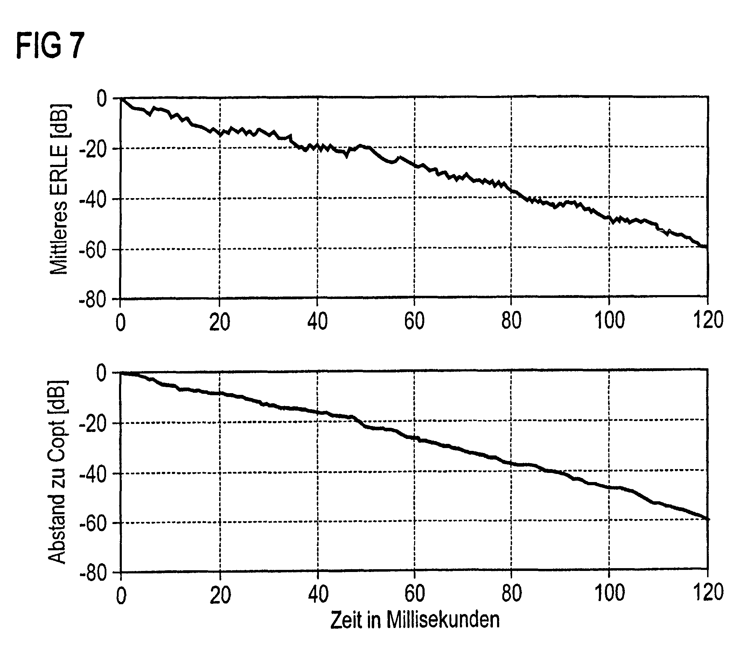

Im folgenden werden an Hand der Figuren 7 bis 9 zwei Ausführungsbeispiele der erfindungsgemäßen Digitalfiltereinrichtung mit einem Echounterdrückungsfilter nach dem Stand der Technik hinsichtlich ihrer Konvergenzeigenschaften verglichen. Die Anzahl N der Filterkoeffizienten $c_0$ bis $c_{N-1}$ ist sowohl für die beiden Ausführungsbeispiele der Erfindung als auch für das bekannte Echounterdrückungsfilter mit 64 angesetzt. Als Maß für die Konvergenz der Koeffizientenadaption, d.h. für die Geschwindigkeit, mit welcher der aktuelle Satz der 64 Filterkoeffizienten an einen optimalen Satz angepaßt wird, werden im folgenden zwei Größen verwendet, nämlich die mittlere Dämpfung ERLE, "Error Return Loss Enhancement", des Echopfades EP und die Abweichung eines die aktuellen Filterkoeffizienten zusammenfassenden Koeffizientenvektors von einem optimalen Koeffizientenvektor Copt, durch den die optimalen Filterkoeffizienten gegeben sind.

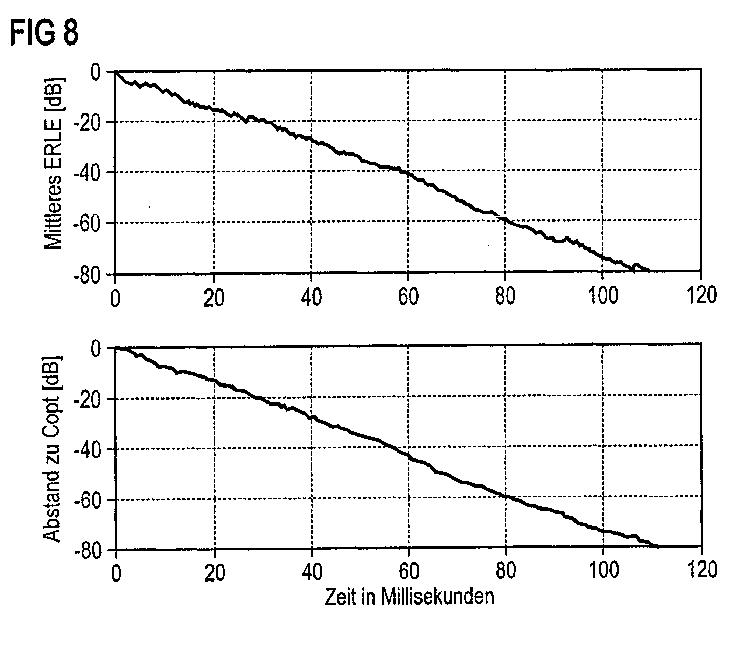

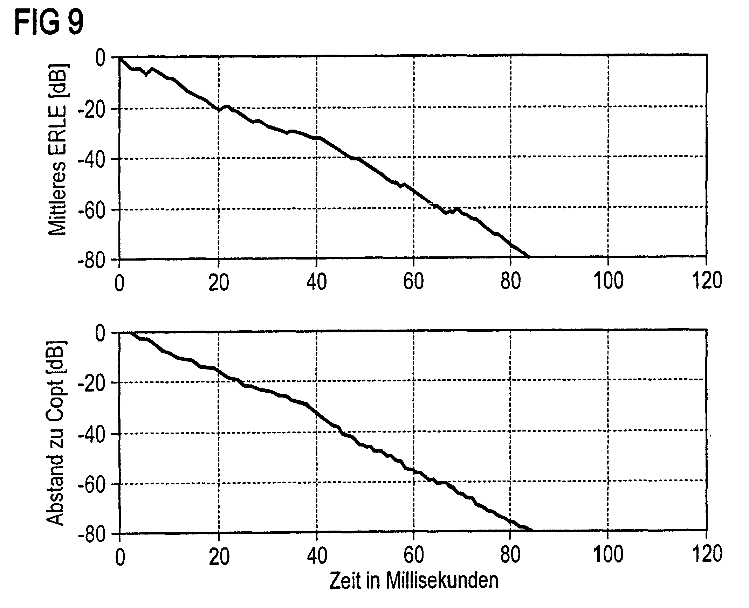

Figur 7 illustriert das Konvergenzverhalten eines konventionellen Echounterdrückungsfilters, das nach dem LMS-Algorithmus arbeitet. Bei der konventionellen Echokompensation wird keine Abtastratenerhöhung und Dekorrelation des Ansagesignals und des Spracheingabesignals vorgenommen. Zum Vergleich ist in Figur 8 das Konvergenzverhalten der Digitalfiltereinrichtung nach Figur 5 dargestellt, in der die Konstante k des Verzögerungsgliedes 52 für dieses Ausführungsbeispiel mit 0 angesetzt ist. Der zeitliche Verlauf der mittleren Dämpfung ERLE des Echopfades EP und der Abweichung von dem optimalen Koeffizientenvektor Copt spiegeln das deutlich verbesserte Konvergenzverhalten der erfindungsgemäßen Digitalfiltereinrichtung wieder. Wird die Konstante k vergrößert, z.B. so, daß sie größer oder gleich der halben Anzahl der Filterkoeffizienten ist, so kann das Konvergenzverhalten der Digitalfiltereinrichtung nochmals deutlich verbessert werden. In Figur 9 ist das Konvergenzverhalten eines Ausführungsbeispiels der Digitalfiltereinrichtung nach Figur 5 dargestellt, in welcher die Konstante k auf 32 gesetzt ist. Durch diese Maßnahme wird die Korrelation zwischen aufeinanderfolgenden Abtastwerten des interpolierten Eingangssignals x und zwischen aufeinanderfolgenden Abtastwerten des interpolierten Spracheingabesignals s weiter reduziert, so daß die Adaption der Filterkoeffizienten im Rahmen des LMS-Algorithmus deutlich schneller vollzogen werden kann.

**Patentansprüche**

1. Verfahren zur Koeffizientenadaption in einer adaptiven Digitalfiltereinrichtung,
   bei dem die Abtastrate eines digitalen Eingangssignals (An) und eines digitalen Referenzsignals (Sp) von einem vorgegebenen niedrigen Wert um einen Faktor M auf einen vorgegebenen hohen Wert erhöht wird,
   die Abtastwerte des mit der hohen Abtastrate abgetasteten Eingangssignals (Anm) und des mit der hohen Abtastrate abgetasteten Referenzsignals (Spm) zumindest bis zu einem gewissen Grad dekorreliert werden,
   ein nichtrekursives adaptives Digitalfilter (22) aus dem dekorrelierten Eingangssignal (x) ein Kompensationssignal (y) basierend auf N Filterkoeffizienten ($c_0$ bis $c_{N-1}$) erzeugt, die in einer mit der hohen Abtastrate betriebenen Adaptionseinheit (44) in Abhängigkeit eines Differenzsignals (d) aus dekorreliertem Referenzsignal (s) und Kompensationssignal (y) entsprechend den kleinsten mittleren Fehlerquadraten bestimmt werden,
   und bei dem die Abtastrate des Differenzsignals (d) von dem vorgegebenen hohen Wert um den Faktor M auf den vorgegebenen niedrigen Wert verringert wird.

2. Verfahren nach Anspruch 1, **dadurch gekennzeichnet, daß** die Abtastwerte des mit der hohen Abtastrate abgetasteten Eingangssignals (Anm) und des mit der hohen Abtastrate abgetasteten Referenzsignals (Spm) in gleicher Weise dekorreliert werden und mindestens für die den ursprünglichen Abtastzeitpunkten zugeordneten Abtastwerte des Differenzsignals (d) eine Kompensation der Dekorrelation vorgenommen wird.

3. Verfahren nach Anspruch 2, **dadurch gekennzeichnet, daß** das Eingangssignal (An) einer ersten Interpolationseinrichtung (18) und das Referenzsignal (Sp) einer zweiten Interpolationseinrichtung (20) zugeführt werden, in denen jeweils die Abtastratenerhöhung durch einen Abtastratenerhöher (28, 32) und die anschließende Dekorrelation durch ein Dekorrelationsfilter (30, 34) vorgenommen werden.

4. Verfahren nach Anspruch 3, **dadurch gekennzeichnet, daß** das Differenzsignal (d) einer Dezimatoreinrichtung (24) zugeführt wird, in der die Kompensation der Dekorrelation durch ein Ausgleichsfilter (36) und die anschließende Abtastratenverringerung durch einen Abtastratenerniedriger (38) vorgenommen werden.

5. Verfahren nach Anspruch 3 oder 4, **dadurch gekennzeichnet, daß** durch den Abtastratenerhöher (28, 32) zwischen aufeinanderfolgenden, den ursprünglichen Abtastzeitpunkten zugeordneten Abtastwerten M-1 Zwischenwerte eingefügt werden.

6. Verfahren nach Anspruch 5, **dadurch gekennzeichnet, daß** die Zwischenwerte gleich Null sind.

7. Verfahren nach Anspruch 5 oder 6, **dadurch gekennzeichnet, daß** durch den Abtastratenerniedriger (38) M-1 Abtastwerte des Differenzsignals (d) ausgeblendet werden, die zwischen den ursprünglichen Abtastzeitpunkten liegen.

8. Verfahren nach einem der Ansprüche 6 oder 7, **dadurch gekennzeichnet, daß** das erste und das zweite Dekorrelationsfilter (30, 34) jeweils M Dekorrelationsteilfilter ($IFT_0$ bis $IFT_{M-1}$) enthalten, die mit der niedrigen Abtastrate betrieben werden können und deren Übertragungsfunktionen $H'_i$ die Übertragungsfunktion H' des ersten und des zweiten Dekorrelationsfilters (30, 34) nach folgender Beziehung ergeben

$$(1) \qquad H'(z) = \sum_{i=0}^{M-1} z^{-i} H'_i(z^M)$$

mit $= e^{j\omega T}$, worin $\omega$ die Kreisfrequenz, T eine der hohen Abtastrate entsprechende kurze Abtastperiode und j die imaginäre Einheit sind.

9. Verfahren nach Anspruch 8, **dadurch gekennzeichnet, daß** das Ausgleichsfilter (36) ein erstes Ausgleichsteilfilter ($DFT_0$) enthält, das mit der niedrigen Abtastrate betrieben wird und eine Übertragungsfunktion $H_0''$ hat, für welche die Beziehung

$$(2) \qquad H_0''(z^M) \cdot H_0'(z^M) = z^{-\alpha}$$

zumindest näherungsweise erfüllt ist, worin $\alpha$ eine nichtnegative Konstante und $H_0'$ die Übertragungsfunktion des ersten Dekorrelationsteilfilters ($IFT_0$) des ersten und des zweiten Dekorrelationsfilters (30, 34) bezeichnet, welches die den ursprünglichen Abtastzeitpunkten zugeordneten Abtastwerte ermittelt.

10. Verfahren nach Anspruch 9, **dadurch gekennzeichnet, daß** das erste Dekorrelationsteilfilter ($IFT_0$) und das erste Ausgleichsteilfilter ($DFT_0$) Durchgangsfilter sind, deren Übertragungsfunktionen $H_0'$ und $H_0''$ die Beziehung

$$(3) \qquad H_0'(z^M) = H_0''(z^M) =$$

erfüllen.

11. Verfahren nach Anspruch 9 oder 10, **dadurch gekennzeichnet, daß** das Ausgleichsfilter (36) weitere M-1 Ausgleichsteilfilter enthält, die mit der niedrigen Abtastrate betrieben werden und deren Übertragungsfunktionen $H_i''$ mit der Übertragungsfunktion $H_0''$ des ersten Ausgleichsteilfilters ($DFT_0$) die Übertragungsfunktion H'' des Ausgleichsfilters (36) nach der Beziehung

$$(4) \qquad H''(z) = \sum_{i=0}^{M-1} z^{-i} H_i''(z^M)$$

ergeben.

12. Verfahren nach Anspruch 10 oder 11, **dadurch gekennzeichnet, daß** die M Dekorrelationsteilfilter ($IFT_0$ bis $IFT_{M-1}$) des ersten und des zweiten Dekorrelationsfilters (30, 34) jeweils parallel geschaltet sind, ihnen das mit der kurzen Abtastperiode abgetastete Eingangssignal (Anm) bzw. das Referenzsignal (Spm) zugeführt wird und ihre Ausgänge über eine Reihenanordnung miteinander verbunden sind, in der M-1 Verzögerungsglieder ($VG_0$ bis $VG_{M-2}$), die jeweils einer der kurzen Abtastperiode entsprechende Signalverzögerung bewirken, und M Additionsglieder ($AD_0$ bis $AD_{M-1}$) in alternierender Folge angeordnet sind.

13. Verfahren nach einem der vorhergehenden Ansprüche, **dadurch gekennzeichnet, daß** das adaptive Digitalfilter (22) ausgestattet ist mit einer Verzögerungskette (46) von N-1 Verzögerungsgliedern, die das dekorrelierte Eingangssignal (x) jeweils um eine der niedrigen Abtastrate entsprechende lange Abtastperiode verzögern, einer von der Verzögerungskette abzweigenden Parallelanordnung (48) von N Multiplikationsgliedern (46), die durch die Adaptionseinheit (44) jeweils mit einem der N Filterkoeffizienten ($C_0$ bis $C_{N-1}$) angesteuert werden, und mit einer Reihenanordnung von N-1 Additionsgliedern (50), welche die Ausgänge der Multiplikationsglieder miteinander verknüpft und das Kompensationssignal (y) an ein weiteres Additionsglied (26) ausgibt, daß weiterhin diesem Additionsglied (26) das dekorrelierte Referenzsignal (s) zugeführt wird, und das Additionsglied aus dem Kompensationssignal (y) und dem Referenzsignal (s) das Differenzsignal (d) ermittelt und dieses der Adaptionseinheit (44) des adaptiven Digitalfilters (22) zuführt.

14. Verfahren nach einem der vorhergehenden Ansprüche, **dadurch gekennzeichnet, daß** es zur Echokompensation in einem sprachgesteuerten Ansagesystem (10) verwendet wird.

15. Adaptive Digitalfiltereinrichtung zum Durchführen des Verfahrens nach einem der vorhergehenden Ansprüche, mit einer ersten Interpolationseinrichtung (18), die einen ersten Abtastratenerhöher (28), der die Abtastrate eines digitalen Eingangssignals (An) von einem vorgegebenen niedrigen Wert um einen Faktor M auf einen vorgegebenen hohen Wert erhöht, und ein erstes Dekorrelationsfilter (30) enthält, das die Abtastwerte des mit der hohen Abtastrate abgetasteten Eingangssignals (Anm) zumindest bis zu einem gewissen Grad dekorreliert, einer zweiten Interpolationseinrichtung (20), die einen zweiten Abtastratenerhöher (32), der die Abtastrate eines digitalen Referenzsignals (Sp) von dem vorgegebenen niedrigen Wert um den Faktor M auf den vorgegebenen hohen Wert erhöht, und ein zweites Dekorrelationsfilter (34) enthält, das die Abtastwerte des mit der hohen Abtastrate abgetasteten Referenzsignals (Spm) zumindest bis zu einem gewissen Grad dekorreliert, einem nichtrekursiven adaptiven Digitalfilter (22), das aus dem dekorrelierten Eingangssignal (x) ein Kompensationssignal (y) basierend auf N Filterkoeffizienten ($c_0$ bis $C_{N-1}$) erzeugt, die in einer mit der hohen Abtastrate betriebenen Adaptionseinheit (44) in Abhängigkeit eines Differenzsignals (d) aus dekorreliertem Referenzsignal (s) und Kompensationssignal (y) entsprechend den kleinsten mittleren Fehlerquadraten bestimmt werden, und einer Dezimatoreinrichtung (24), die die Abtastrate des Differenzsignals (d) von dem vorgegebenen hohen Wert um den Faktor M auf den vorgegebenen niedrigen Wert verringert.

16. Digitalfiltereinrichtung nach Anspruch 15, **dadurch gekennzeichnet, daß** das erste Dekorrelationsfilter (30) und das zweite Dekorrelationsfilter (34) funktionsgleiche Komponenten sind und daß die Dezimatoreinrichtung (24) ein Ausgleichsfilter (36) enthält, das mindestens für die den ursprünglichen Abtastzeitpunkten zugeordneten Abtastwerte des Differenzsignals (d) eine Kompensation der durch das erste und das zweite Dekorrelationsfilter (30, 34) erfolgten Dekorrelation vornimmt.

17. Digitalfiltereinrichtung nach Anspruch 16, **dadurch gekennzeichnet, daß** das erste und das zweite Dekorrelationsfilter (30, 34) jeweils M Teilfilter ($IFT_0$ bis $IFT_{M-1}$) enthalten, die mit der niedrigen Abtastrate betrieben werden können und deren Übertragungsfunktionen $H'_i$ die Übertragungsfunktion H' des ersten und des zweiten Dekorrelationsfilters (30, 34) nach folgender Beziehung ergeben

$$(1) \qquad H'(z) = \sum_{i=0}^{M-1} z^{-i} H'_i (z^M)$$

mit = $e^{j\omega T}$, worin $\omega$ die Kreisfrequenz, T eine der hohen Abtastrate entsprechende kurze Abtastperiode und j die imaginäre Einheit sind.

18. Digitalfiltereinrichtung nach Anspruch 17, **dadurch gekennzeichnet, daß** das Ausgleichsfilter (36) ein erstes Ausgleichsteilfilter ($DFT_0$) enthält, das mit der niedrigen Abtastrate betrieben wird und eine Übertragungsfunktion $H_0''$ hat, für welche die Beziehung

$$(2) \qquad H_0''(z^M) \cdot H_0'(z^M) = z^{-\alpha}$$

zumindest näherungsweise erfüllt ist, worin $\alpha$ eine nichtnegative Konstante und $H_0'$ die Übertragungsfunktion des

ersten Dekorrelationsteilfilters (IFT$_0$) des ersten und des zweiten Dekorrelationsfilters (30, 34) bezeichnet, welches die den ursprünglichen Abtastzeitpunkten zugeordneten Abtastwerte ermittelt.

19. Digitalfiltereinrichtung nach Anspruch 18, **dadurch gekennzeichnet, daß** das erste Dekorrelationsteilfilter (IFT$_0$) und das erste Ausgleichsteilfilter (DFT$_0$) Durchgangsfilter sind, deren Übertragungsfunktionen H$_0$' und H$_0$'' die Beziehung

$$(3) \qquad H_0{}'(z^M) = H_0{}''(z^M) =$$

erfüllen.

20. Digitalfiltereinrichtung nach Anspruch 18 oder 19, **dadurch gekennzeichnet, daß** das Ausgleichsfilter (36) weitere M-1 Ausgleichsteilfilter enthält, die mit der niedrigen Abtastrate betrieben werden und deren Übertragungsfunktionen H$_i$'' mit der Übertragungsfunktion H$_0$'' des ersten Ausgleichsteilfilters (DFT$_0$) die Übertragungsfunktion H'' des Ausgleichsfilters (36) nach der Beziehung

$$(4) \qquad H''(z) = \sum_{i=0}^{M-1} z^{-i} H_i{}''(z^M)$$

ergeben.

21. Digitalfiltereinrichtung nach Anspruch 19 oder 20, **dadurch gekennzeichnet, daß** die M Dekorrelationsteilfilter (IFT$_0$ bis IFT$_{M-1}$) des ersten und des zweiten Dekorrelationsfilters (30, 34) jeweils parallel geschaltet sind, ihnen das mit der kurzen Abtastperiode abgetastete Eingangssignal (Anm) bzw. das Referenzsignal (Spm) zugeführt wird und ihre Ausgänge über eine Reihenanordnung miteinander verbunden sind, in der M-1 Verzögerungsglieder (VG$_0$ bis VG$_{M-2}$), die jeweils einer der kurzen Abtastperiode entsprechende Signalverzögerung bewirken, und M Additionsglieder (AD$_0$ bis AD$_{M-1}$) in alternierender Folge angeordnet sind.

22. Digitalfiltereinrichtung nach einem der Ansprüche 15 bis 21, **dadurch gekennzeichnet, daß** das adaptive Digitalfilter (22) ausgestattet ist mit einer Verzögerungskette (46) von N-1 Verzögerungsgliedern, die das dekorrelierte Eingangssignal (x) jeweils um eine der niedrigen Abtastrate entsprechende lange Abtastperiode verzögern, einer von der Verzögerungskette abzweigenden Parallelanordnung (48) von N Multiplikationsgliedern (46), die durch die Adaptionseinheit (44) jeweils mit einem der N Filterkoeffizienten (C$_0$ bis C$_{N-1}$) angesteuert werden, und mit einer Reihenanordnung von N-1 Additionsgliedern (50), welche die Ausgänge der Multiplikationsglieder miteinander verknüpft und das Kompensationssignal (y) an ein weiteres Additionsglied (26) ausgibt, daß weiterhin diesem Additionsglied (26) das dekorrelierte Referenzsignal (s) zugeführt wird, und das Additionsglied aus dem Kompensationssignal (y) und dem Referenzsignal (s) das Differenzsignal (d) ermittelt und dieses der Adaptionseinheit (44) des adaptiven Digitalfilters (22) zuführt.

**Claims**

1. Method for coefficient adaptation in an adaptive digital filter device,
   in which the sampling rate of a digital input signal (An) and of a digital reference signal (Sp) is increased by a factor M for a prescribed low value to a prescribed high value,
   the samples of the input signal (Anm) sampled at the high sampling rate and of the reference signal (Spm) sampled at the high sampling rate are decorrelated at least to a certain degree,
   a non-recursive adaptive digital filter (22) takes the decorrelated input signal (x) and produces a compensation signal (y) on the basis of N filter coefficients (C$_0$ to C$_{N-1}$) which are determined in an adaptation unit (44) operated at the high sampling rate on the basis of a difference signal (d) from the decorrelated reference signal (s) and the compensation signal (y) in line with the least mean squares,
   and in which the sampling rate of the difference signal (d) is reduced by the factor M from the prescribed high value to the prescribed low value.

2. Method according to Claim 1, **characterized in that** the samples of the input signal (Anm) sampled at the high sampling rate and of the reference signal (Spm) sampled at the high sampling rate are decorrelated in the same way and compensation for the decorrelation is provided at least for the samples of the difference signal (d) which are associated with the original sampling times.

3. Method according to Claim 2, **characterized in that** the input signal (An) is supplied to a first interpolation device (18) and the reference signal (Sp) is supplied to a second interpolation device (20), in which devices the sampling rate increase is performed by a sampling rate increaser (28, 32) and the subsequent decorrelation is performed by a decorrelation filter (30, 34), respectively.

4. Method according to Claim 3, **characterized in that** the difference signal (d) is supplied to a decimator device (24) in which the compensation for the decorrelation is provided by a compensating filter (36) and the subsequent sampling rate reduction is performed by a sampling rate reducer (38).

5. Method according to Claim 3 or 4, **characterized in that** the sampling rate increaser (28, 32) inserts M-1 intermediate values between successive samples associated with the original sampling times.

6. Method according to Claim 5, **characterized in that** the intermediate values are equal to zero.

7. Method according to Claim 5 or 6, **characterized in that** the sampling rate reducer (38) masks out M-1 samples of the difference signal (d) which are situated between the original sampling times.

8. Method according to one of Claims 6 and 7, **characterized in that** the first and the second decorrelation filter (30, 34) respectively contain M decorrelation subfilters ($IFT_0$ to $IFT_{M-1}$) which can be operated at the low sampling rate and whose transfer functions $H'_i$ give the transfer function H' of the first and of the second decorrelation filter (30, 34) according to the following relationship:

$$H'(z) = \sum_{i=0}^{M-1} z^{-i} H'_i(z^M)$$

(1)

with $= e^{j\omega T}$, where $\omega$ is the angular frequency, T is a short sampling period corresponding to the high sampling rate and j is the imaginary unit.

9. Method according to Claim 8, **characterized in that** the compensating filter (36) contains a first compensating subfilter ($DFT_0$) which is operated at the low sampling rate and has a transfer function $H_0''$ for which the relationship:

$$(2) \quad H_0''(z^M) \cdot H_0'(z^M) = z^{-\alpha}$$

is satisfied at least approximately, where $\alpha$ denotes a non-negative constant and $H_0'$ denotes the transfer function of the first decorrelation subfilter ($IFT_0$) of the first and of the second decorrelation filter (30, 34), which ascertains the samples associated with the original sampling times.

10. Method according to Claim 9, **characterized in that** the first decorrelation subfilter ($IFT_0$) and the first compensating subfilter ($DFT_0$) are transmission filters whose transfer functions $H_0'$ and $H_0''$ satisfy the relationship

$$(3) \quad H_0'(z^M) = H_0''(z^M) = \quad .$$

**11.** Method according to Claim 9 or 10, **characterized in that** the compensating filter (36) contains further M-1 compensating subfilters which are operated at the low sampling rate and whose transfer functions $H_i''$ with the transfer function $H_0''$ of the first compensating subfilter ($DFT_0$) give the transfer function $H''$ of the compensating filter (36) according to the relationship

$$H''(z) = \sum_{i=0}^{M-1} z^{-i} H_i''(z^M)$$

(4)

**12.** Method according to Claim 10 or 11, **characterized in that** the M decorrelation subfilters ($IFT_0$ to $IFT_{M-1}$) of the first and of the second decorrelation filter (30, 34) are respectively connected in parallel, are supplied with the input signal (Anm) sampled using the short sampling period and with the reference signal (Spm), and their outputs are connected to one another by means of a series arrangement in which M-1 delay elements ($VG_0$ to $VG_{M-2}$), which respectively bring about a signal delay corresponding to the short sampling period, and M addition elements ($AD_0$ to $AD_{M-1}$) are arranged alternately.

**13.** Method according to one of the preceding claims, **characterized in that** the adaptive digital filter (22) is equipped with a delay line (46) of N-1 delay elements which respectively delay the decorrelated input signal (x) by a long sampling period corresponding to the low sampling rate, with a parallel arrangement (48), branching off from the delay line, of N multiplication elements (46) which are respectively actuated by the adaptation unit (44) using one of the N filter coefficients ($C_0$ to $C_{N-1}$), and with a series arrangement of N-1 addition elements (50) which logically combines the outputs of the multiplication elements and outputs the compensation signal (y) to a further addition element (26),
and **in that** also this addition element (26) is supplied with the decorrelated reference signal (s), and the addition element takes the compensation signal (y) and the reference signal (s) and ascertains the difference signal (d) and supplies it to the adaptation unit (44) of the adaptive digital filter (22).

**14.** Method according to one of the preceding claims, **characterized in that** it is used for echo compensation in a voice-controlled announcement system (10).

**15.** Adaptive digital filter device for carrying out the method according to one of the preceding claims,
having a first interpolation device (18) which contains a first sampling rate increaser (28), which increases the sampling rate of a digital input signal (An) by a factor M from a prescribed low value to a prescribed high value, and a first decorrelation filter (30), which decorrelates the samples of the input signal (Anm) sampled at the high sampling rate at least to a certain degree,
a second interpolation device (20) which contains a second sampling rate increaser (32), which increases the sampling rate of a digital reference signal (Sp) by the factor M from the prescribed low value to the prescribed high value, and a second decorrelation filter (34), which decorrelates the samples of the reference signal (Spm) sampled at the high sampling rate at least to a certain degree,
a non-recursive adaptive digital filter (22) which takes the decorrelated input signal (x) and produces a compensation signal (y) on the basis of N filter coefficients ($c_0$ to $c_{N-1}$) which are determined in an adaptation unit (44) operated at the high sampling rate on the basis of a difference signal (d) from the decorrelated reference signal (s) and the compensation signal (y) in line with the least mean squares, and
a decimator device (24) which reduces the sampling rate of the difference signal (d) by the factor M from the prescribed high value to the prescribed low value.

**16.** Digital filter device according to Claim 15, **characterized in that** the first decorrelation filter (30) and the second decorrelation filter (34) are components with the same function and **in that** the decimator device (24) contains a compensating filter (36) which provides compensation for the decorrelation performed by the first and the second decorrelation filter (30, 34) at least for the samples of the difference signal (d) which are associated with the original sampling times.

**17.** Digital filter device according to Claim 16, **characterized in that** the first and the second decorrelation filter (30, 34) respectively contain M subfilters ($IFT_0$ to $IFT_{M-1}$) which can be operated at the low sampling rate and whose transfer functions $H'_i$ give the transfer function $H'$ of the first and of the second decorrelation filter (30, 34) according to the following relationship:

$$H'(z) = \sum_{i=0}^{M-1} z^{-i} H'_i(z^M)$$

$$(1)$$

with $= e^{j\omega T}$, where $\omega$ is the angular frequency, T is a short sampling period corresponding to the high sampling rate and j is the imaginary unit.

18. Digital filter device according to Claim 17, **characterized in that** the compensating filter (36) contains a first compensating subfilter (DFT$_0$) which is operated at the low sampling rate and has a transfer function $H_0''$ for which the relationship

$$(2) \quad H_0''(z^M) \cdot H_0'(z^M) = z^{-\alpha}$$

is satisfied at least approximately, where $\alpha$ denotes a non-negative constant and $H_0'$ denotes the transfer function of the first decorrelation subfilter (IFT$_0$) of the first and of the second decorrelation filter (30, 34), which ascertains the samples associated with the original sampling times.

19. Digital filter device according to Claim 18, **characterized in that** the first decorrelation subfilter (IFT$_0$) and the first compensating subfilter (DFT$_0$) are transmission filters whose transfer functions $H_0'$ and $H_0''$ satisfy the relationship

$$(3) \quad H_0'(z^M) = H_0''(z^M) = \;.$$

20. Digital filter device according to Claim 18 or 19, **characterized in that** the compensating filter (36) contains further M-1 compensating subfilters which are operated at the low sampling rate and whose transfer functions $H_i''$ with the transfer function $H_0''$ of the first compensating subfilter (DFT$_0$) give the transfer function $H''$ of the compensating filter (36) according to the relationship

$$H''(z) = \sum_{i=0}^{M-1} z^{-i} H_i''(z^M)$$

$$(4) \quad .$$

21. Digital filter device according to Claim 19 or 20, **characterized in that** the M decorrelation subfilters (IFT$_0$ to IFT$_{M-1}$) of the first and of the second decorrelation filter (30, 34) are respectively connected in parallel, are supplied with the input signal (Anm) sampled using the short sampling period and with the reference signal (Spm), and their outputs are connected to one another by means of a series arrangement in which M-1 delay elements (VG$_0$ to VG$_{M-2}$), which respectively bring about a signal delay corresponding to the short sampling period, and M addition elements (AD$_0$ to AD$_{M-1}$) are arranged alternately.

22. Digital filter device according to one of Claims 15 to 21, **characterized in that** the adaptive digital filter (22) is equipped with a delay line (46) of N-1 delay elements which respectively delay the decorrelated input signal (x) by a long sampling period corresponding to the low sampling rate, with a parallel arrangement (48), branching off from the delay line, of N multiplication elements (46) which are respectively actuated by the adaptation unit (44) using one of the N filter coefficients (C$_0$ to C$_{N-1}$), and with a series arrangement of N-1 addition elements (50) which logically combines the outputs of the multiplication elements and outputs the compensation signal (y) to a further addition element (26),
and **in that** also this addition element (26) is supplied with the decorrelated reference signal (s), and the addition element takes the compensation signal (y) and the reference signal (s) and ascertains the difference signal (d) and supplies it to the adaptation unit (44) of the adaptive digital filter (22).

**Revendications**

1. Procédé d'adaptation de coefficients dans un dispositif de filtrage numérique adaptatif,
dans lequel on augmente d'un facteur M le taux d'échantillonnage d'un signal d'entrée numérique (An) et d'un signal de référence numérique (Sp) pour passer d'une petite valeur prescrite à une grande valeur prescrite,
dans lequel on effectue au moins jusqu'à un certain degré la décorrélation des valeurs échantillonnées du signal d'entrée (Anm) échantillonné avec le grand taux d'échantillonnage et du signal de référence (Spm) échantillonné avec le grand taux d'échantillonnage,
dans lequel un filtre numérique adaptatif non récursif (22) produit à partir du signal d'entrée décorrélé (x) un signal de compensation (y) en se basant sur N coefficients de filtrage ($c_0$ à $c_{N-1}$) qui sont déterminés dans une unité d'adaptation (44) fonctionnant avec le grand taux d'échantillonnage en fonction d'un signal de différence (d) à partir du signal de référence décorrélé (s) et du signal de compensation (y) selon les moindres carrés d'erreur moyens, et dans lequel on réduit le taux d'échantillonnage du signal de différence (d) du facteur M pour passer de la grande valeur prescrite à la petite valeur prescrite.

2. Procédé selon la revendication 1, **caractérisé par le fait que** l'on effectue de la même manière la décorrélation des valeurs échantillonnées du signal d'entrée (Anm) échantillonné avec le grand taux d'échantillonnage et du signal de référence (Spm) échantillonné avec le grand taux d'échantillonnage et que l'on effectue une compensation de la décorrélation au moins pour les valeurs échantillonnées du signal de différence (d) qui sont associées aux instants d'échantillonnage initiaux.

3. Procédé selon la revendication 2, **caractérisé par le fait que** l'on envoie le signal d'entrée (An) à un premier dispositif d'interpolation (18) et le signal de référence (Sp) à un deuxième dispositif d'interpolation (20), dispositifs dans lesquels on effectue à chaque fois l'augmentation de taux d'échantillonnage au moyen d'un dispositif d'augmentation de taux d'échantillonnage (28, 32) et la décorrélation consécutive au moyen d'un filtre de décorrélation (30, 34).

4. Procédé selon la revendication 3, **caractérisé par le fait que** l'on envoie le signal de différence (d) à un dispositif de décimation (24) dans lequel on effectue la compensation de la décorrélation au moyen d'un filtre d'équilibrage (36) et la diminution de taux d'échantillonnage consécutive au moyen d'un dispositif de diminution de taux d'échantillonnage (38).

5. Procédé selon la revendication 3 ou 4, **caractérisé par le fait que** le dispositif d'augmentation de taux d'échantillonnage (28, 32) insère M - 1 valeurs intermédiaires entre des valeurs échantillonnées successives associées aux instants d'échantillonnage initiaux.

6. Procédé selon la revendication 5, **caractérisé par le fait que** les valeurs intermédiaires sont nulles.

7. Procédé selon la revendication 5 ou 6, **caractérisé par le fait que** le dispositif de diminution de taux d'échantillonnage (38) supprime M - 1 valeurs échantillonnées du signal de différence (d) qui se trouvent entre les instants d'échantillonnage initiaux.

8. Procédé selon l'une des revendications 6 ou 7, **caractérisé par le fait que** le premier et le deuxième filtre de décorrélation (30, 34) contiennent chacun M filtres partiels de décorrélation ($IFT_0$ à $IFT_{M-1}$) qui peuvent être exploités avec le petit taux d'échantillonnage et dont les fonctions de transfert $H'_i$ donnent la fonction de transfert H' du premier et du deuxième filtre de décorrélation (30, 34) selon la relation suivante :

$$(1) \quad H'(z) = \sum_{i=0}^{M-1} z^{-i} H'_i(z^M)$$

avec = e$^{j\omega T}$, $\omega$ étant la fréquence angulaire, T une courte période d'échantillonnage correspondant au grand taux d'échantillonnage et j l'unité imaginaire.

9. Procédé selon la revendication 8, **caractérisé par le fait que** le filtre d'équilibrage (36) contient un premier filtre partiel d'équilibrage (DFT$_0$) qui est exploité avec le petit taux d'échantillonnage et qui a une fonction de transfert H$_0$'' pour laquelle la relation

$$(2) \quad H_0'' \ (z^M) \ \cdot \ H_0' \ (z^M) \ = \ z^{-\alpha}$$

est au moins approximativement satisfaite, $\alpha$ étant une constante non négative et H$_0$' la fonction de transfert du premier filtre partiel de décorrélation (IFT$_0$) du premier et du deuxième filtre de décorrélation (30, 34) qui détermine les valeurs échantillonnées associées aux instants d'échantillonnage initiaux.

10. Procédé selon la revendication 9, **caractérisé par le fait que** le premier filtre partiel de décorrélation (IFT$_0$) et le premier filtre partiel d'équilibrage (DFT$_0$) sont des filtres transitoires dont les fonctions de transfert H$_0$' et H$_0$'' satisfont à la relation

$$(3) \quad H_0' \ (z^M) \ = \ H_0'' \ (z^M) \ =$$

11. Procédé selon la revendication 9 ou 10, **caractérisé par le fait que** le filtre d'équilibrage (36) contient M - 1 autres filtres partiels d'équilibrage qui sont exploités avec le petit taux d'échantillonnage et dont les fonctions de transfert H$_i$'' donnent avec la fonction de transfert H$_0$'' du premier filtre partiel d'équilibrage (DFT$_0$) la fonction de transfert H'' du filtre d'équilibrage (36) selon la relation

$$(4) \quad H'' \ (z) \ = \ \sum_{i=0}^{M-1} \ z^{-i} \ H_i'' \ (z^M)$$

12. Procédé selon la revendication 10 ou 11, **caractérisé par le fait que** les M filtres partiels de décorrélation (IFT$_0$ à IFT$_{M-1}$) du premier et du deuxième filtre de décorrélation (30, 34) sont branchés à chaque fois en parallèle, qu'ils reçoivent le signal d'entrée (Anm) respectivement le signal de référence (Spm) échantillonné avec la période d'échantillonnage courte et que leurs sorties sont reliées entre elles par l'intermédiaire d'un montage série dans lequel M - 1 éléments de retardement (VG$_0$ à VG$_{M-2}$), provoquant chacun un retard de signal correspondant à la période d'échantillonnage courte, et M éléments additionneurs (AD$_0$ à AD$_{M-1}$) sont agencés en alternance.

13. Procédé selon l'une des revendications précédentes, **caractérisé par le fait que** le filtre numérique adaptatif (22) est équipé d'une chaîne de retardement (46) de N - 1 éléments de retardement qui retardent le signal d'entrée décorrélé (x) à chaque fois d'une période d'échantillonnage longue correspondant au petit taux d'échantillonnage, d'un montage parallèle (48) dérivant de la chaîne de retardement et constitué de N éléments de multiplication (46) qui sont commandés par l'unité d'adaptation (44) à chaque fois avec l'un des N coefficients de filtrage (C$_0$ à C$_{N-1}$) et d'un montage série de N - 1 éléments d'addition (50) qui combine les sorties des éléments de multiplication entre elles et qui délivre le signal de compensation (y) à un autre élément d'addition (26), et on envoie le signal de référence décorrélé (s) à cet élément d'addition (26), l'élément d'addition détermine le signal de différence (d) à partir du signal de compensation (y) et du signal de référence (s) et il l'envoie à l'unité d'adaptation (44) du filtre numérique adaptatif (22).

14. Procédé selon l'une des revendications précédentes, **caractérisé par le fait qu'**il est utilisé pour la compensation d'écho dans un système d'annonce (10) commandé vocalement.

15. Dispositif de filtrage numérique adaptatif pour la mise en oeuvre du procédé selon l'une des revendications précédentes, avec un premier dispositif d'interpolation (18) qui contient un premier dispositif d'augmentation de taux d'échantillonnage (28), qui augmente d'un facteur M le taux d'échantillonnage d'un signal d'entrée numérique (An) pour passer d'une petite valeur prescrite à une grande valeur prescrite, et un premier filtre de décorrélation (30) qui effectue au moins jusqu'à un certain degré la décorrélation des valeurs échantillonnées du signal d'entrée (Anm) échantillonné avec le grand taux d'échantillonnage,

avec un deuxième dispositif d'interpolation (20) qui contient un deuxième dispositif d'augmentation de taux d'échantillonnage (32), qui augmente du facteur M le taux d'échantillonnage d'un signal de référence numérique (Sp) pour passer de la petite valeur prescrite à la grande valeur prescrite, et un deuxième filtre de décorrélation (34), qui effectue au moins jusqu'à un certain degré la décorrélation des valeurs échantillonnées du signal de référence (Spm) échantillonné avec le grand taux d'échantillonnage,

avec un filtre numérique adaptatif non récursif (22) qui produit à partir du signal d'entrée décorrélé (x) un signal de compensation (y) en se basant sur N coefficients de filtrage ($C_0$ à $C_{N-1}$) qui sont déterminés dans une unité d'adaptation (44) fonctionnant avec le grand taux d'échantillonnage en fonction d'un signal de différence (d) à partir du signal de référence décorrélé (s) et du signal de compensation (y) selon les moindres carrés d'erreur moyens, et avec un dispositif de décimation (24) qui réduit du facteur M le taux d'échantillonnage du signal de différence (d) pour passer de la grande valeur prescrite à la petite valeur prescrite.

16. Dispositif de filtrage numérique selon la revendication 15, **caractérisé par le fait que** le premier filtre de décorrélation (30) et le deuxième filtre de décorrélation (34) sont des composants à la fonction identique et que le dispositif de décimation (24) contient un filtre d'équilibrage (36) qui effectue une compensation de la décorrélation effectuée par le premier et le deuxième filtre de décorrélation (30, 34) au moins pour les valeurs échantillonnées du signal de différence (d) qui sont associées aux instants d'échantillonnage initiaux.

17. Dispositif de filtrage numérique selon la revendication 16, **caractérisé par le fait que** le premier et le deuxième filtre de décorrélation (30, 34) contiennent chacun M filtres partiels ($IFT_0$ à $IFT_{M-1}$) qui peuvent être exploités avec le petit taux d'échantillonnage et dont les fonctions de transfert $H'_i$ donnent la fonction de transfert H' du premier et du deuxième filtre de décorrélation (30, 34) selon la relation suivante :

$$(1) \quad H'(z) = \sum_{i=0}^{M-1} z^{-i} H'_i(z^M)$$

avec $= e^{j\omega T}$, ω étant la fréquence angulaire, T une courte période d'échantillonnage correspondant au grand taux d'échantillonnage et j l'unité imaginaire.

18. Dispositif de filtrage numérique selon la revendication 17, **caractérisé par le fait que** le filtre d'équilibrage (36) contient un premier filtre partiel d'équilibrage ($DFT_0$) qui est exploité avec le petit taux d'échantillonnage et qui a une fonction de transfert $H_0''$ pour laquelle la relation

$$(2) \quad H_0''(z^M) \cdot H_0'(z^M) = z^{-\alpha}$$

est au moins approximativement satisfaite, α étant une constante non négative et $H_0'$ la fonction de transfert du premier filtre partiel de décorrélation ($IFT_0$) du premier et du deuxième filtre de décorrélation (30, 34) qui détermine les valeurs échantillonnées associées aux instants d'échantillonnage initiaux.

19. Dispositif de filtrage numérique selon la revendication 18, **caractérisé par le fait que** le premier filtre partiel de décorrélation ($IFT_0$) et le premier filtre partiel d'équilibrage ($DFT_0$) sont des filtres transitoires dont les fonctions de transfert $H_0'$ et $H_0''$ satisfont à la relation

$$(3) \quad H_0'(z^M) = H_0''(z^M) =$$

20. Dispositif de filtrage numérique selon la revendication 18 ou 19, **caractérisé par le fait que** le filtre d'équilibrage (36) contient M - 1 autres filtres partiels d'équilibrage qui sont exploités avec le petit taux d'échantillonnage et dont les fonctions de transfert $H_i''$ donnent avec la fonction de transfert $H_0''$ du premier filtre partiel d'équilibrage ($DFT_0$) la fonction de transfert H'' du filtre d'équilibrage (36) selon la relation

$$(4) \quad H''(z) = \sum_{i=0}^{M-1} z^{-i} H_i''(z^M)$$

**21.** Dispositif de filtrage numérique selon la revendication 19 ou 20, **caractérisé par le fait que** les M filtres partiels de décorrélation ($IFT_0$ à $IFT_{M-1}$) du premier et du deuxième filtre de décorrélation (30, 34) sont branchés à chaque fois en parallèle, qu'ils reçoivent le signal d'entrée (Anm) respectivement le signal de référence (Spm) échantillonné avec la période d'échantillonnage courte et que leurs sorties sont reliées entre elles par l'intermédiaire d'un montage série dans lequel M - 1 éléments de retardement ($VG_0$ à $VG_{M-2}$), provoquant chacun un retard de signal correspondant à la période d'échantillonnage courte, et M éléments additionneurs ($AD_0$ à $AD_{M-1}$) sont agencés en alternance.

**22.** Dispositif de filtrage numérique selon l'une des revendications 15 à 21, **caractérisé par le fait que** le filtre numérique adaptatif (22) est équipé d'une chaîne de retardement (46) de N - 1 éléments de retardement qui retardent le signal d'entrée décorrélé (x) à chaque fois d'une période d'échantillonnage longue correspondant au petit taux d'échantillonnage, d'un montage parallèle (48) dérivant de la chaîne de retardement et constitué de N éléments de multiplication (46) qui sont commandés par l'unité d'adaptation (44) à chaque fois avec l'un des N coefficients de filtrage ($C_0$ à $C_{N-1}$) et d'un montage série de N - 1 éléments d'addition (50) qui combine les sorties des éléments de multiplication entre elles et qui délivre le signal de compensation (y) à un autre élément d'addition (26), et le signal de référence décorrélé (s) est envoyé à cet élément d'addition (26), l'élément d'addition détermine le signal de différence (d) à partir du signal de compensation (y) et du signal de référence (s) et il l'envoie à l'unité d'adaptation (44) du filtre numérique adaptatif (22).

FIG 1

FIG 2

FIG 3

18,20

An,Sp  28,32

Anm,Spm

M

IFT$_0$

VE$_1$'

MT

N$_1$'

IFT$_1$

VE$_{M-1}$

MT

N$_{M-1}$

IFT$_{M-1}$

AD$_0$  x,s

VG$_0$

T

AD$_1$

30,34

T  VG$_{M-2}$

24

d

DFT$_0$

36

M  p

38

EP 0 909 029 B1

FIG 4

EP 0 909 029 B1

FIG 5

EP 0 909 029 B1

## FIG 6

EP 0 909 029 B1

FIG 7

FIG 8

Mittleres ERLE [dB]

Abstand zu Copt [dB]

Zeit in Millisekunden

# FIG 9

EP 0 909 029 B1

**EP 0 909 029 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• EP O554494 B1

**In der Beschreibung aufgeführte Nicht-Patentliteratur**

• **S. YAMAMOTO ; K. TAKEDA ; N. INONE ; S. KUROIWA ; M. NAITOH.** A voice-activated telephone exchange system and its field trial. *Proceedings of 2nd IEEE Workshop on Interactive Voice Technology for Telecommunications Applications,* 26. September 1994, 21-26

• **M. SONDHI ; W.L. KELLERMANN.** Adaptive Echo Cancellation for Speech Signals. *Advances in Speech Signal Processing von S. Furui, M. Sondhi,* 1992, 327-356